(19) Europäisches Patentamt
European Patent Office
Office européen des brevets

(11) EP 2 577 328 B1

(12) **EUROPEAN PATENT SPECIFICATION**

(45) Date of publication and mention
of the grant of the patent:
**09.04.2014 Bulletin 2014/15**

(21) Application number: **11723489.8**

(22) Date of filing: **07.06.2011**

(51) Int Cl.:
**G01R 15/24** (2006.01)

(86) International application number:
**PCT/EP2011/059399**

(87) International publication number:
**WO 2011/154408 (15.12.2011 Gazette 2011/50)**

(54) **HIGH-VOLTAGE SENSOR WITH AXIALLY OVERLAPPING ELECTRODES**

HOCHSPANNUNGSSENSOR MIT ÜBERLAPPENDEN ELEKTRODEN

CAPTEUR DE HAUTE TENSION AVEC ELECTRODES ENCHEVAUCHES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **07.06.2010 PCT/EP2010/057872**

(43) Date of publication of application:
**10.04.2013 Bulletin 2013/15**

(73) Proprietor: **ABB Research Ltd.
8050 Zürich (CH)**

(72) Inventors:
• **WILDERMUTH, Stephan**
**CH-5243 Mülligen (CH)**
• **BOHNERT, Klaus**
**CH-5452 Oberrohrdorf (CH)**

• **KOCH, Norbert**
**CH-8953 Dietikon (CH)**
• **CZYZEWSKI, Jan**
**CH-8134 Adliswil (CH)**
• **MARCHESE, Sergio Vincenzo**
**CH-8050 Zürich (CH)**

(74) Representative: **ABB Patent Attorneys
C/o ABB Schweiz AG
Intellectual Property (CH-LI/IP)
Brown Boveri Strasse 6
5400 Baden (CH)**

(56) References cited:
**CH-A- 547 496        DE-A1- 19 838 354
US-A- 4 362 897       US-A- 6 140 810
US-B1- 6 252 388      US-B1- 6 380 725**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Technical Field

The invention relates to a voltage sensor for measuring a voltage between a first and a second contact point, in particular to a voltage sensor with an insulator, such as a body of an insulating material, extending between the contact points and with electrodes arranged in said body. The invention also relates to an assembly of several such voltage sensors arranged in series.

Background Art

Optical high-voltage sensors often rely on the electro-optic effect (Pockels effect) in crystalline materials such as $Bi_4Ge_3O_{12}$ (BGO) [1]. An applied voltage introduces a differential optical phase shift between two orthogonal linearly polarized light waves propagating through the crystal. This phase shift is proportional to the voltage. At the end of the crystal the light waves commonly interfere at a polarizer. The resulting light intensity serves as a measure for the phase shift and thus the voltage.

US 4,904,931 [2] and US 6,252,388 [3] disclose a sensor in which the full line voltage (up to several 100 kV) is applied over the length of a single BGO crystal. The crystal length is typically between 100 mm and 250 mm. An advantage is that the sensor signal corresponds to the true voltage, i.e. the line integral of the electric field along the crystal. However, the electric field strengths at the crystal are very high. In order to obtain sufficient dielectric strength, the crystal is mounted in a hollow high-voltage insulator made of fiber-reinforced epoxy filled with $SF_6$-gas under pressure for electric insulation. The electrodes at the crystal ends are designed so that the field along the crystal is reasonably homogeneous. The insulator diameter is sufficiently large to keep the field strength in the air outside the insulator below critical limits. Typically, the field strength decreases with increasing radial distance from the crystal.

US 6,252,388 [4] describes a voltage sensor which uses several small electro-optical crystals mounted at selected positions along the longitudinal axis of a hollow high-voltage insulator. The crystals measure the electric fields at their locations. The sum of these local field measurements serves as an approximation of the voltage applied to the insulator. Here, the field strengths at a given voltage are significantly lower than with the design of [2] and insulation with nitrogen at atmospheric pressure is sufficient. However, since the sensor does not measure the line integral of the field but derives the signal from the field strengths at a few selected points between ground and high voltage, extra measures (permittivity-shielding) to stabilize the electric field distribution are necessary to avoid excessive approximation errors [5].

A drawback of the above concepts is the requirement of an expensive high-voltage insulator of large size. The outer dimensions are similar to the ones of corresponding conventional inductive voltage transformers or capacitive voltage dividers. Thus, the attractiveness of such optical sensors is limited.

Ref. [6] describes a sensor in which the voltage is partitioned among several quartz crystals, each with a length of e.g. 150 mm. Here, the piezo-electric deformation of the crystals under the applied voltage is transmitted to an optical fiber, which carries at least two different light modes. The light waves travelling through the fiber experience a differential optical phase shift in proportion to the voltage. The ends of each crystal are again equipped with electrodes that provide a relatively homogenous field distribution at the crystals. The electrodes of adjacent crystals are interconnected with electric conductors. The voltage partitioning reduces the electric field strengths compared to a solution with a single crystal and thus makes it possible to mount the crystals in a relatively slender high-voltage insulator of relatively low cost. The hollow volume of the insulator is filled with soft polyurethane. A drawback is that relatively large corona rings are required in order to ensure that the voltage drops at the individual crystals are of comparable magnitude. Furthermore, enhanced electric field strengths occur particularly at the outer surface of the insulator near the positions of the individual electrodes: The peak fields must be kept below the breakdown field of air and therefore prevent still smaller insulator diameter.

Ref. [7] describes an electro-optical voltage sensor of the type as in [2, 3], but with an electro-optic crystal embedded in silicone. A hollow high-voltage insulator of large size and $SF_6$-gas insulation is thus avoided. As in [6] the voltage may be partitioned among several crystals.

Other prior art is a concept as known from high-voltage bushings. There is often a need in high-voltage systems to pass high-voltage conductors through or near by other conductive parts which are at ground potential (for example at power transformers). For this purpose the high-voltage conductor is contained within a feed-through insulator. The insulator contains several layers of metal foil concentric with the high-voltage conductor and insulated from each other. By appropriately choosing the length of the individual cylinders of metal foils, the distribution of the electric field within and near the bushing can be controlled in such a way that a relatively homogeneous voltage drop from high-voltage to ground potential occurs along the outer surface of the bushing [8, 9, 10].

CH 547 496 discloses high voltage insulators that are equipped with staggered electrodes and have optical fibers arranged between and around the electrodes.

Disclosure of the Invention

The problem to be solved by the present invention is therefore to provide a voltage sensor for measuring a voltage between a first and a second contact point of alternative design.

This problem is solved by the voltage sensor of claim 1. Accordingly, the voltage sensor comprises an insulator, or briefly sensor insulator. The insulator is elongate and extends along an axial direction between the first and the second contact points. An electric field sensor is arranged within at least one sensing cavity, in particular within exactly one sensing cavity, inside the insulator. Typically, the length of the sensing cavity is significantly shorter than the length of the insulator. Further, a plurality of conductive electrodes is arranged in the insulator. The electrodes are mutually separated by the insulating material and capacitively coupled to each other. At least a subset of the electrodes (or the whole set of the electrodes) is arranged such that each electrode of the subset axially overlaps at least another one of the electrodes from the subset.

The electrodes allow to control the surfaces of electric equipotential such that on the outer surface of the insulator the voltage drops over the full length of the insulator while inside the insulator the voltage drops over the (shorter) length of the sensing cavity. Preferably the voltage drops essentially homogeneously both along the outer surface of the insulator and over the length of the sensing cavity.

Whereas in the absence of the voltage sensor the normal to the surfaces of equipotential is essentially parallel to the axial direction, the normal is perpendicular to the axial direction in the vicinity of the electrodes if such electrodes are present.

The electrodes allow to concentrate the electric field within the sensing cavity with a field strength larger than the (average) field strength at the outside of the voltage sensor, i.e. larger than the voltage between the contact points divided by the distance between the contact points.

Advantageously, at least one of the electrodes is a shield electrode radially surrounding said sensing cavity. The electrode can capacitively be coupled to two subsets of electrodes and it prevents the high electric field within the sensing cavity from extending into the air outside the sensor.

Advantageously, the voltage sensor comprises two sets of mutually staggered electrodes.

The invention in its preferred embodiments provides a high-voltage sensor with a slender and lightweight insulator of low cost. The electrodes provide electric field steering and, optionally, obviate the need for electrodes directly applied to the field sensor. A solid-state insulation may suffice (no oil or gas).

The invention also relates to an assembly of such high-voltage sensors in series. Hence, a combination of several modules of the same or differently shaped or dimensioned high-voltage sensor can be used for measuring a large range of different voltage levels.

Other advantageous embodiments are listed in the dependent claims as well as in the description below.

Brief Description of the Drawings

The invention will be better understood and objects other than those set forth above will become apparent from the following detailed description thereof. Such description makes reference to the annexed drawings of exemplary embodiments, wherein:

Fig. 1 is a sectional view of a voltage sensor;
Fig. 2 shows (a) a single voltage sensor as well as assemblies of two (b) and four (c) voltage sensors;
Fig. 3 shows (a) a sectional view of a field sensor within a voltage sensor and (b) the arrangement of two field sensors;
Fig. 4 shows an optical field sensor and the alignment of the axes of the electro-optic crystal, the retarder, and the polarizers;
Fig. 5 shows (a) an optical field sensor with polarizers operated in transmission, (b) an optical field sensor with retarder and polarizers operated in transmission, (c) an optical field sensor with polarizer operated in reflection, (d) an optical field sensor with retarder and polarizer operated in reflection, (e) an optical field sensor with reflective prism, and (f) a series arrangement of two optical field sensors;
Fig. 6 shows the source and signal processing module and its optical connections to a series of optical field sensors;
Fig. 7 shows a field sensor with end electrodes or contacting electrodes;
Fig. 8 shows, when seen in axial direction, (a) electrode layers with overlapping ends and (b) electrodes forming closed cylinders;
Fig. 9 shows alternative electrode assemblies for a given rated voltage: (a) voltage sensor with a single field sensor of length 21, (b) voltage sensor with two separate field sensors each of length 1;
Fig. 10 shows an optical field sensor operated in reflection with optics for generation of two signals at quadrature from a single sensing element;
Fig. 11 shows an assembly of two field sensors arranged in series;
Fig. 12 shows a detailed cross-sectional view of a mounting and contacting electrode for a sensor body; and
Fig. 13 shows high-voltage sensors having insulators of varying radial thickness.

## Modes for Carrying Out the Invention

*Definitions*

The term "high voltage" designates typically voltages exceeding 10 kV, in particular exceeding 100 kV.

The terms "radial" and "axial" are understood in respect to the axial direction (along axis 8, z-axis) of the sensor, with radial designating a direction perpendicular to the axial direction and axial designating a direction parallel to the axial direction.

A given electrode "axially overlapping" another electrode indicates that there is a range of axial coordinates (z-coordinates) that the two electrodes have in common.

*Voltage sensor with electric field steering*

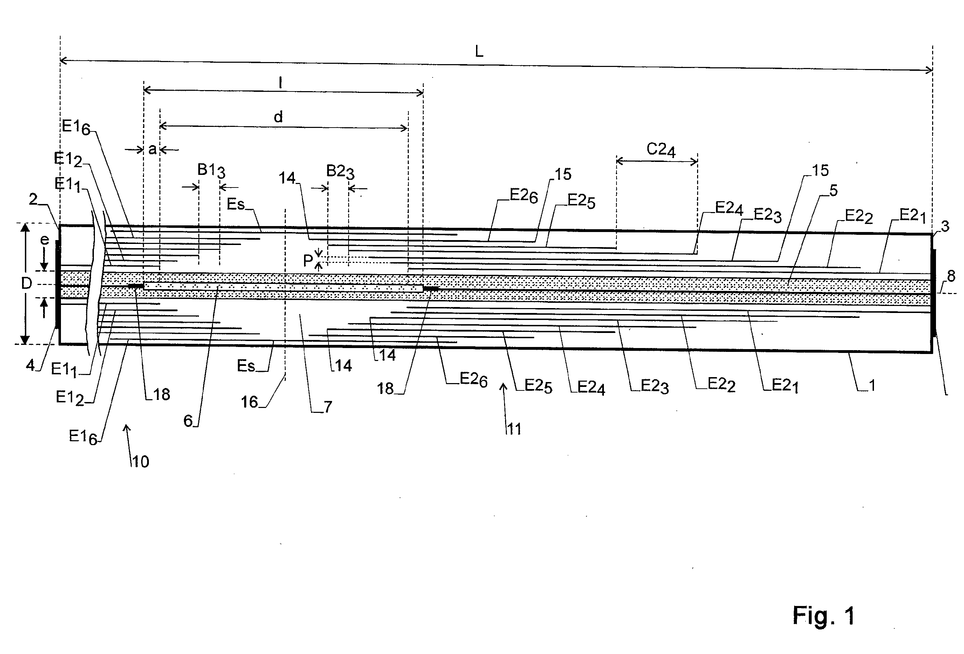

Fig. 1 shows an embodiment of a voltage sensor. The present embodiment comprises an elongate, advantageously rod-shaped body of an insulating material forming an insulator 1, briefly named sensor insulator 1, such as epoxy resin or paper impregnated with epoxy resin. It extends between a first contact point 2 and a second contact point 3, both of which may be equipped with metal contacts 4 for contacting neighboring voltage sensors or voltage potentials. In the present embodiment insulator 1 is cylindrical. It has a central bore 5 filled with a filler material.

An electric field sensor 6, in the present embodiment an optical field sensor, such as a cylinder-shaped crystal of $Bi_4Ge_3O_{12}$ (BGO) or $Bi_4Si_3O_{12}$ (BSO), is placed inside bore 5 within a sensing cavity 7. Sensing cavity 7 is advantageously at a center between first contact point 2 and second contact point 3 in order to minimize the distortion of the electrical field around the voltage sensor.

A reference plane 16 perpendicular to axis 8 of the device and arranged at the center of sensing cavity 7 is used in the following as geometric reference for describing the geometry of some of the electrodes. Note: Here it is assumed that sensing cavity 7 is located in the middle between contact points 2 and 3. Asymmetric positions of sensing cavity 7 will be briefly considered further below. Further, it is noted that the term "cavity" does not imply that there is an absence of insulating material in the respective region.

A plurality of electrodes E is arranged in insulator 1. The electrodes E are mutually separated by the insulating material of insulator 1 and capacitively coupled to each other. In the present embodiment, the electrodes E are formed by metal cylinders (consisting e.g. of thin aluminum foil) of different axial extensions concentric to longitudinal axis 8. The electrodes E control the surfaces of equipotential and the distribution of the electric field outside and inside insulator 1. The lengths (i.e. axial extensions) of the individual electrodes E and their radial and axial positions are chosen such that the surfaces of equipotential are spaced essentially equidistantly along the full length of the outer surface of insulator 1 and are concentrated, but again with essentially equal distances, in sensing cavity 7. As a result the applied voltage V drops uniformly along the outer rod surface as well as along the sensing cavity. Preferably, the length of the field sensor is such that the sensor is essentially exposed to full voltage drop, i.e. the sensor length is at least the length of the sensing cavity.

At least one of the electrodes E is a shield electrode $E_s$ and radially surrounds sensing cavity 7, thereby capacitively coupling the two sets of electrodes that are separated by reference plane 16.

One electrode, designated $E1_1$, is electrically connected to first contact point 2, and subsequently called the "first primary electrode". Another electrode, designated $E2_1$, is electrically connected to second contact point 3, and subsequently called the "second primary electrode". These two electrodes carry the potential of the contact points 2 and 3, respectively. The other electrodes form a capacitive voltage divider between the two primary electrodes and therefore are at intermediate potentials.

In addition to shield electrode $E_s$, the electrodes comprise a first set of electrodes, named $E1_i$ with i = 1 ... N1, and a second set of electrodes, named $E2_i$ with i = 1 ... N2, with second index i being or running independently from the first index i. For symmetry reasons, N1 advantageously equals N2. In the embodiment of Fig. 1, N1 = N2 = 6, but the actual number of electrodes may vary.

The electrodes $E1_i$ of the first set are arranged in a first region 10 of insulator 1, which extends from the center of sensing cavity 7 to first contact point 2, while the electrodes $E2_i$ of the second set are arranged in a second region 11 of insulator 1, which extends from the center of sensing cavity 7 to second contact point 3.

Electrode $E1_1$ of the first set of electrodes forms the first primary electrode and electrode $E2_1$ of the second set forms the second primary electrode. These electrodes are radially closest to longitudinal axis 8, with the other electrodes being arranged at larger distances from longitudinal axis 8.

As mentioned above, the various electrodes overlap in axial direction and are of a generally "staggered" design. Advantageously, one or more of the following characteristics are used:

a) For each set j (j = 1 or 2) of electrodes, the electrodes $Ej_i$ and $Ej_{i+1}$ axially overlap along an "overlapping section". In this overlapping section the electrode $Ej_{i+1}$ is arranged radially outside from the electrode $Ej_i$.
b) For each set j of electrodes:

- Each electrode has a center end (as illustrated by reference number 14 for some of the electrodes in Fig. 1) facing reference plane 16 of the sensor and a contact end (as illustrated by reference number 15) axially opposite to center end 14,
- Center end 14 of electrode $Ej_{i+1}$ is closer to reference plane 16 than center end 14 of the electrode $Eji$ and contact end 15 of electrode $Ej_{i+1}$ is closer to reference plane 16 than contact end 15 of the electrode $Ej_i$, hence electrode $Ej_{i+1}$ is shifted axially towards the center as compared to electrode $Ej_i$, and $Ej_{i+1}$ is shifted radially towards the outside as compared to $Ej_i$.
- Contact end 15 of the electrode $Ej_{i+1}$ has an axial distance $Cj_i$ from contact end 15 of the electrode $Ej_i$, and center end 14 of electrode $Ej_{i+1}$ has an axial distance $Bj_i$ from center end 14 of electrode $Ej_i$, and
- The electrodes $Ej_i$ and $Ej_{i+1}$ axially overlap between contact end 14 of electrode $Eji_{+1}$ and center end 14 of electrode $Ej_i$.

c) The distances $Bj_i$ and $Cj_i$ can be optimized according to the desired field design. In particular, for obtaining a stronger field within sensing cavity 7 than outside the voltage sensor, the axial distance $Bj_i$ is advantageously chosen to be smaller than the corresponding axial distance $Cj_i$, for all i and j.
d) For most designs, if a homogeneous field is desired in sensing cavity 7, the axial distances $Bj_i$ should be substantially equal to a common distance B, i.e. they should all be the same. Similarly, if a homogeneous field is desired at the surface and outside the voltage sensor, the axial distances $Cj_i$ are advantageously substantially equal to a common distance C, i.e. they are also all the same.
e) Shield electrode $E_s$ should advantageously have an axial overlap with at least one electrode of the first set and also with at least one electrode of the second set. This, on the one hand, provides improved protection against the high electrical fields in sensing cavity 7 reaching to the surface of the device. On the other hand, it provides good capacitive coupling between the two sets of electrodes via the shield electrode, thereby decreasing the corresponding voltage drop. To further improve this capacitive coupling as well as the field homogeneity within sensing cavity 7, shield electrode Es advantageously has an axial overlap with the radially outmost electrode $E1_6$ of the first set and the radially outmost electrode $E2_6$ of the second side and is arranged radially outside from these outmost electrodes $E1_6$ and $E2_6$.
f) In order to evenly distribute the fields outside and inside the voltage sensor the electrodes are advantageously arranged symmetrically in respect to reference plane 16 of the device.
g) For the same reason, the electrodes are advantageously cylindrical and/or coaxial to each other, in particular coaxial with the longitudinal axis 8.

Fig. 1 further illustrates some other advantageous aspects:

- Field sensor 6 (which is e.g. an electro-optical crystal) is advantageously cylindrical with a length 1 and is positioned in central bore 5 (diameter e) of insulator 1 (outer diameter D and length L), and within sensing cavity 7.
- Insulator 1 contains, as an example, six electrodes in both the first and the second set. These electrodes $Ej_i$, as well as shield electrode Es, are advantageously of a metal foil, concentric with field sensor 6 and insulator 1.
- With $Bj_i$ and $Cj_i$ chosen as described above, preferably, the electrodes of the two sets are equally spaced in radial direction with a uniform separation distance P between neighboring electrodes, and also the radial distance between the outmost electrodes $E1_6$, $E2_6$ of each set to shield electrode $E_s$ is equal to P. Again, this contributes to distribute the electrical fields more evenly both inside and outside insulator 1.
- Preferably, the innermost, primary electrodes $E1_1$ and $E2_1$ protrude over the axial ends of field sensor 6 by a length a, i.e. field sensor 6 axially overlaps with both primary electrodes. The length a is advantageously sufficiently large so that the field strength in the immediate vicinity of the ends of field sensor 6 and beyond is essentially zero, i.e. field sensor 6 is exposed to the full voltage applied between contact points 2 and 3.
- Preferably, shield electrode $E_s$ is positioned at mid-distance between the contact ends 2, 3.
- The primary electrodes $E1_1$ and $E2_1$ are in contact with the two electric potentials, e.g. ground and high-voltage potentials, at the corresponding contact points 2, 3 by means of the metal contacts 4.
- Preferably, insulator 1 is equipped with sheds 19, consisting e.g. of silicone, on its outer surface (not shown in Fig.

1), which provide increased creep distance between high-voltage and ground potential for outdoor operation and, in particular, for high-voltage operation.

The field steering by the electrodes $Ej_i$ and $E_s$ avoids excessive local peak fields both outside and inside insulator 1. As a result the radial dimensions of insulator 1 can be made relatively small without the danger of electric breakdown in the environmental air.

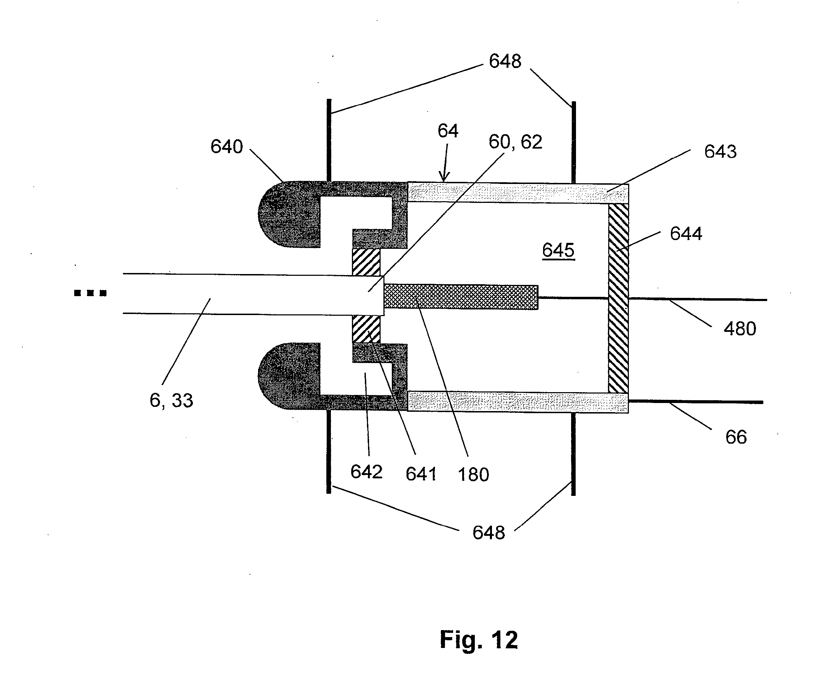

The electric field strength in the immediate vicinity of the two ends of field sensor 6 is essentially zero. The same is true within the bore 5 below and above the sensing element. As a benefit any components, in particular any optical components if an optical field sensor is used, are in a field-free region. This is especially advantageous if an optical field sensor is used, because the various auxiliary optical components, such as retarders, polarizers, and collimators 18, can be located in a field-free environment. See also Fig. 12.

There is no need for field steering electrodes at the crystal ends, which simplifies the sensor assembly. The primary electrodes $E1_1$ and $E2_1$ are in electric contact with the contact points 2, 3 (e.g. ground and high voltage potential). The other electrodes are on intermediary potentials generated by the capacitive voltage divider formed by the electrodes.

Bore 5 is filled with a soft material, e.g. silicone, which provides sufficient dielectric strength. The silicone contains a filler material which ascertains sufficient compressibility and accommodates any thermal expansion of the silicone and insulator 1. The filler may for example consist of micron sized beads made of a soft material or of tiny gas bubbles (such as $SF_6$ gas). The silicone may also serve to hold the field sensor 6 in place and suppress effects of mechanical shock and vibration.

Due to its light weight the voltage sensor may be suspension-mounted in a high-voltage substation.

The dimensions of the voltage sensor and its parts depend on the rated voltage and are chosen such that the sensor meets the requirements of relevant standards for over-voltages, lightning and switching impulse voltages (e.g. Ref. 17). For example, insulator 1 of a 125 kV-module may be an epoxy rod having an overall length L of about 1 m to 1.5 m and a diameter D of 50 mm to 80 mm. The crystal may have a length 1 of 150 mm and a diameter d of 5 mm. The inner bore 5 of the rod may then have a diameter e between 15 and 25 mm. The parameters a, $Bi_j$, $C_{ij}$, D, P are chosen such that the voltage applied to the rod ends drops as uniformly as possible over the length of the crystal within the bore and at the same time over the full length of the epoxy rod at its outer surface. The design may be optimized by using an adequate numerical electric-field simulation tool.

Choosing the distances Bij as well as Cij to be equal as described above also contributes to simple and cost efficient insulator fabrication.

Fig. 1 illustrates but one possible design of the electrodes. It must be noted that, depending on the required size and shape of the sensor, the design of the electrodes may vary.

For example, the electrodes may also be non-cylindrical, e.g. by having an oval cross section or by having varying diameter. The electrodes may e.g. be truncated conical (frustro-conical), their end sections 15 may be flared outwards or their end-sections 14 may be flared inwards.

Each electrode can consist of a continuous conductive sheet, such as a metal foil, or it may e.g. be perforated or have gaps.

*Modular design*

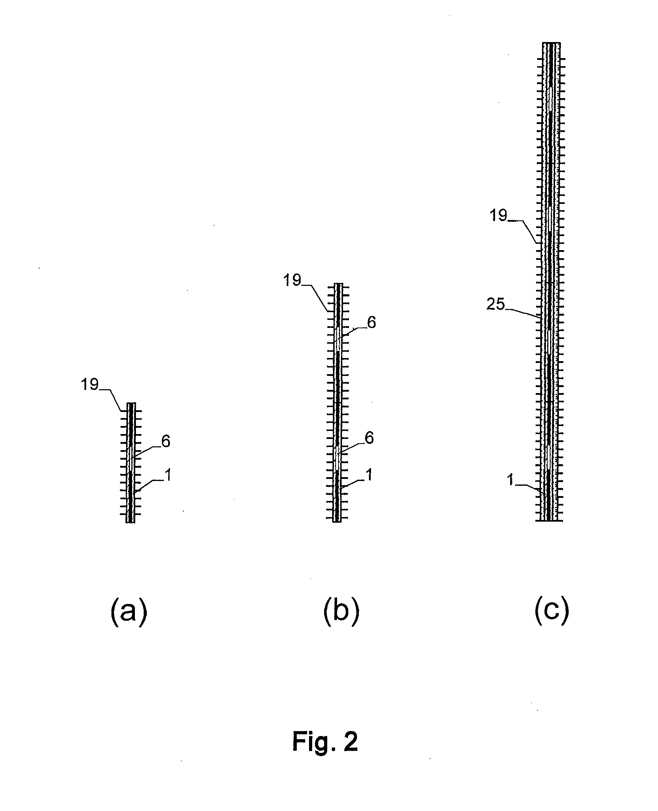

The voltage sensor described above may form a module in an assembly of several voltage sensors arranged in series, such as shown in Fig. 2a. In particular, a module containing a single field sensor 6 as described above may be designed for a rated voltage of e.g. 125 kV or 240 kV. Fig. 2a also shows schematically the sheds 19 applied to the outside of insulator 1.

For operation at 240 kV, two 125 kV modules may be mounted in series (Fig 2b). The primary electrodes $E2_1$ and $E1_2$ of the neighbouring modules are in electric contact at the joint between the two modules. The voltage is then about evenly partitioned on the two field sensors 6. Alternatively, a single continuous insulator (with a length of about twice the length of the individual rods) which contains two field sensors 6 and two corresponding assemblies of field steering electrodes may be used instead of two separate epoxy rods.

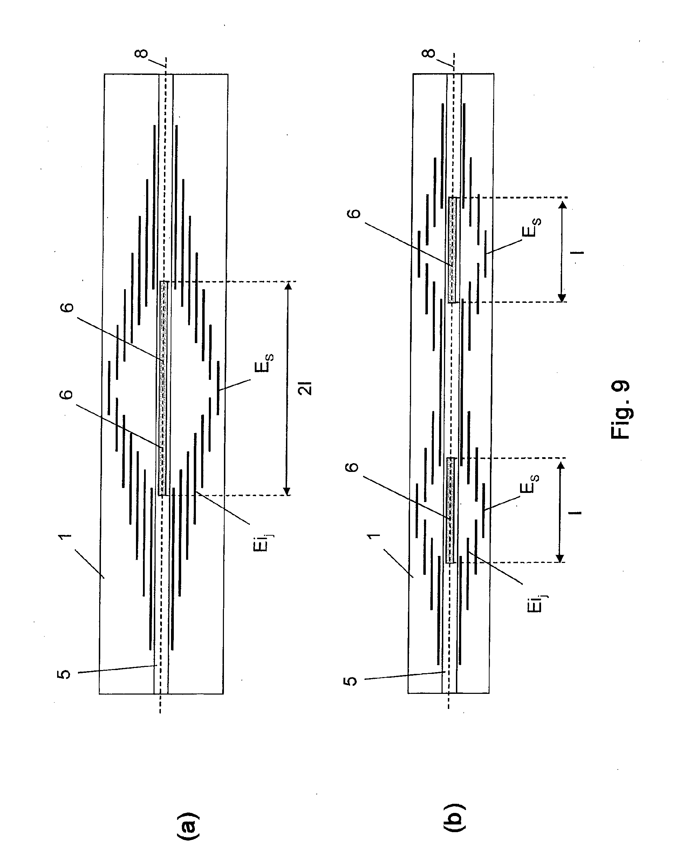

It should be noted that distributing the voltage on two separate crystals of length 1 results in a smaller insulator diameter and thus lower insulator cost than applying the same voltage to a single crystal of length 21 as illustrated in Fig. 9. A single long crystal (Fig. 9a) requires more electrode layers and thus a larger insulator diameter than two shorter crystals (Fig. 9b) in order to keep the field strength between the layers below critical limits.

At even higher operating voltages, a corresponding number of lower voltage modules is arranged in series, e.g. four 125 kV modules for an operating voltage of 420 kV (Fig 2c). To achieve sufficient mechanical strength of the structure, these serial modules may be mounted in a standard hollow core high-voltage outer insulator 25, which is e.g. made of fiber-reinforced epoxy. The hollow volume between the modules and the outer insulator 25 is filled with e.g. polyurethane foam, again, to provide sufficient dielectric strength and to some degree mechanically decouple the modules from the outer insulator 25. In an arrangement like in Fig. 2c the individual insulating bodies 1 are not equipped with silicone sheds but the external or outer insulator 25 is equipped with sheds 19 instead.

Furthermore, the geometry of the field steering electrodes may be chosen somewhat differently for the individual modules for further optimization of the field distribution. Additionally, there may be corona rings at the ground and high-voltage ends of the structure as well as at intermediate positions.

In case of several modules it may be sufficient to equip only one module or a subset of modules with an electric field sensor in case the voltage ratios remain sufficiently stable.

*Field sensor assembly*

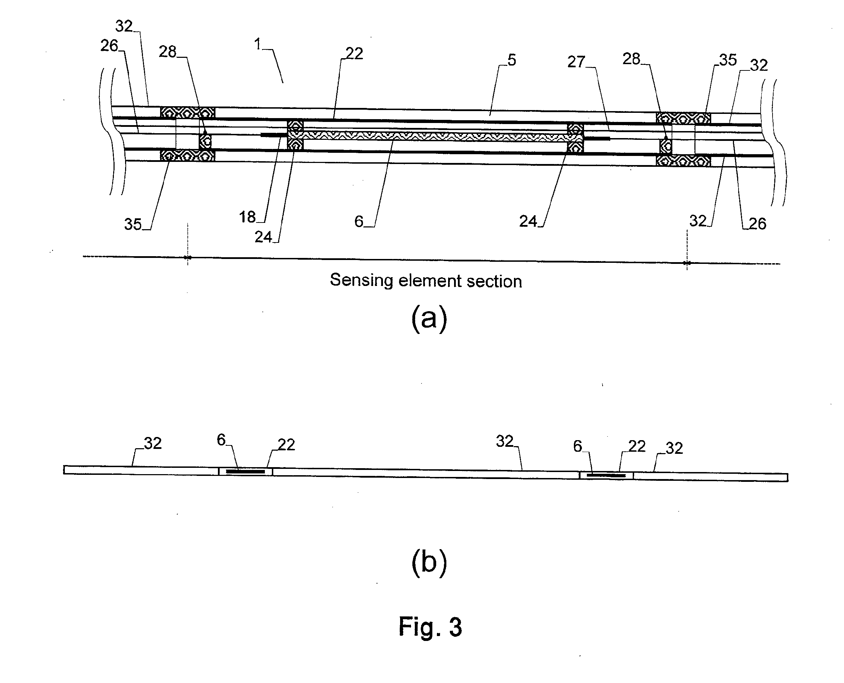

Figs. 3a and 3b illustrate the assembly of field sensor 6 within bore 5 of insulator 1. The specific example is for an optical field sensor, even though similar techniques can, where applicable, also be used for other types of field sensors.

The main features are as follows:

- The whole structure is pre-assembled as a sub-unit and then inserted into bore 5. The remaining hollow volume of bore 5 is subsequently filled with silicone gel as mentioned above. Instead of filling the whole of bore 5, the silicone filling may be restricted to the high-field region in the vicinity of field sensor 6.
- Each field sensor 6, which may e.g. be formed by an electro-optical crystal, is mounted inside a support tube 22, e.g. made of fiber re-enforced epoxy, by means of soft braces 24 in the field free volume at the field sensor ends. Mechanical forces acting on the field sensor are thus kept at a minimum, i.e. the field sensor is mechanically decoupled from the insulating rod.
- For an optical sensor, the fibers 26 that guide the light to and from field sensor 6 have strain reliefs 28 that are part of support tube 22.
- On both sides support tube 22 is connected via flexible joints 35 to spacer tubes 32. The spacer tubes 32 extend to the ends of the insulator 1 or, in case of a series of several field sensors 6 in a single insulator 1, may extend to the adjacent field sensor 6 (Fig. 3b). The flexible joints 35 accommodate for differential thermal expansion of insulator 1 and the various tube segments as well as for a bending of the whole structure, e.g. due to wind forces. The spacer tubes 32 may be composed of several subsections, again with flexible joints in between them.
- If the field sensors 6 are operated in optical transmission as shown in Fig. 3, the return fiber 27 forms a semi-loop in an adequate hollow volume at the end of an individual insulator 1 (not shown) or at the far end of the whole structure, if the insulator is composed of several individual bodies 1 as in Fig. 2b, 2c.

Advantageously, the contact points 2, 3 of insulating insulator 1 are equipped with metal flanges (not shown in Fig. 1). The flanges are in electric contact with metal contacts 4 (or contacts 4 may be comprised by such metal flanges). The flanges facilitate the mounting of the voltage sensor and, in case of a series of several voltage sensor modules, the connection of neighboring modules. The metal flanges may also provide the hollow volume for the above mentioned semi-loop of the return fibers.

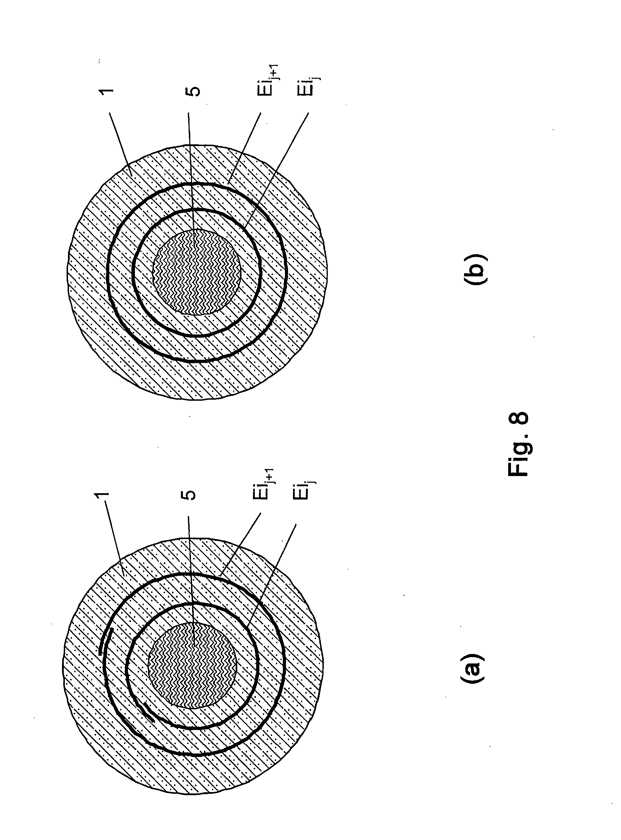

It should be noted that the individual electrodes of the two sets $E1_i$ and $E2_i$ may not form perfect cylinders but for manufacturing reasons may be formed of an aluminum foil, the ends of which overlap as illustrated in Fig. 8a with a thin layer of insulating material between the overlapping ends. Alternatively the overlapping foil ends are in direct contact and thus form electrically closed cylinders, as indicated in Fig. 8b.

*Sensor modifications*

a) Asymmetric location of sensing cavity

In the above description it has been assumed that the sensing cavity is located at mid distance between contact points 2, 3 of insulator 1. Depending on the particular environment of the voltage sensor, it may be conceivable that an asymmetric location of the sensing cavity with respect to contact points 2, 3 is more adequate. Preferably in that case, the two sets of electrodes $E1_i$ and $E2_i$ are also asymmetric and reference plane 16 as well as shield electrode $E_s$ is moved from the center of the cavity towards the contact point at the far end of insulator 1. For example, if the sensor cavity is closer to contact point 2, reference plane 16 and shield electrode Es are shifted towards contact point 3. As a result axial distances $B1_i$ are longer than axial distances $B2_i$ and likewise axial distances $C2_i$ are longer than axial distances $C1_i$. The values within each set $B1_i$ $B2_i$ $C1_i$ $C2_i$ of axial distances may be chosen as equal or may be chosen differently in order to further optimize the field distribution depending on the particular situation. As an extreme case one set of electrodes $E1_i$ or $E2_i$ may be completely omitted.

b) Local field measurement

As the field distribution inside the sensing cavity is rather homogeneous and stable, a local (i.e. essentially point like) electric field measurement, for example at the center of the cavity, can be an option as alternative to or even in combination with a line integration of the field. A local electric field sensor in this sense is a sensor that measured the electric field along only part of the axial extension of the sensing cavity. The local field essentially varies in proportion to the applied voltage. The influence of thermal effects on the local field strength, e.g. due to the thermal expansion of sensing cavity 7, may be compensated in the signal processor, if the temperature is extracted as mentioned below.

As a further alternative to a perfect line integration of the electric field in sensing cavity 7 by means of a long crystal, the voltage may be approximated from several local (point like) field measurements, with the local field sensors arranged at several points within cavity 7 along axis 8. Particularly, such an arrangement can be of advantage, if the length of sensing cavity is chosen relatively long so that it is difficult to cover this length with a single crystal. Such an arrangement may be of interest in case rather high voltages (e. g. 420 kV or higher) are to be measured with a single voltage sensor module.

Still another alternative is to combine several crystals (with their electro-optic axes aligned) to form a longer continuous sensing section.

Furthermore, a combination of several electro-optic crystals with inactive material (such as fused silica) in between as described in [7] and interrogated by a single light beam may be employed.

c) Field sensor with contact electrodes

To ascertain that the total voltage drops over the length of field sensor (6), it can be of advantage if the ends of sensor (6) are equipped with electrodes that are in electric contact with the innermost electrodes $E1_1$ and $E2_1$. The electrodes may be bulk metal parts, transparent electrode layers such as indium tin oxide, or a combination thereof.

d) Voltage measurement in gas-insulated switchgear

Ref. 15 describes an optical voltage sensor for SF6 gas-insulated switchgear. Here, a piezoelectric crystal with an attached fiber is used to measure the voltage between two electrodes at the crystal ends. Other alternatives are an electro-optic crystal or any other kind of optical voltage sensor. The electrodes have considerably larger radial dimensions than the crystal in order to provide a reasonably homogeneous electric field distribution along the crystal.

A capacitively coupled electrode arrangement as shown in Fig. 1 may also be used for voltage sensors in gas insulated switchgear in order to avoid the large size electrodes of [15]. In this case, the two sets of electrodes $E1_i$ and $E2_i$ may again be embedded in an insulating rod as shown in Fig. 1. Alternatively, a solid insulation material may be omitted and be replaced by the insulating SF6 gas of the switchgear system. In the latter case the sets of electrodes may be kept in place by means of insulating spacer parts between the various electrode layers.

Instead of SF6 gas another insulating gas such as nitrogen may be used. A further alternative is vacuum.

In other conceivable applications of the sensor, for example in electric power transformers, a liquid, commonly transformer oil, may be used as the insulating material.

In other words, insulator 1 can also be or comprise a liquid, gas or vacuum, in addition to a solid or any combinations thereof.

*Optical sensor elements*

As mentioned, field sensor 6 is advantageously an electro-optical field sensor, or, in more general terms, an optical sensor introducing a field-dependent phase shift between a first polarisation or mode and a second polarization or mode of light passing through it.

Advantageously, such an optical sensor comprises:

- an electro-optical device with field-dependent birefringence, in particular a crystal or a poled waveguide, such as a poled fiber, exhibiting a Pockels effect, or
- a piezo-electric device, in particular of crystalline quartz or a piezoelectric ceramic, and an optical waveguide carrying at least two modes, wherein said waveguide is connected to the piezo-electric device in such a manner that the length of the waveguide is field-dependent.

Ideally, a voltage sensor measures the path integral of the electric field between two electric potentials, e.g. ground and high voltage potential. This concept is particularly suited for outdoor installations, because the measurement accuracy is not deteriorated by field perturbations, e.g. due to rain or ice or by cross-talk from neighboring phases.

Electro-optic crystals of certain symmetry are well suited to implement this concept [3].

a) Pockels effect

An electric field applied to an electro-optical crystal induces an anisotropic change in the refractive index of the material (birefringence). This birefringence causes a phase shift between two orthogonally linear polarized light waves traversing the crystal (Pockels effect). By measuring this phase shift the applied voltage can be inferred.

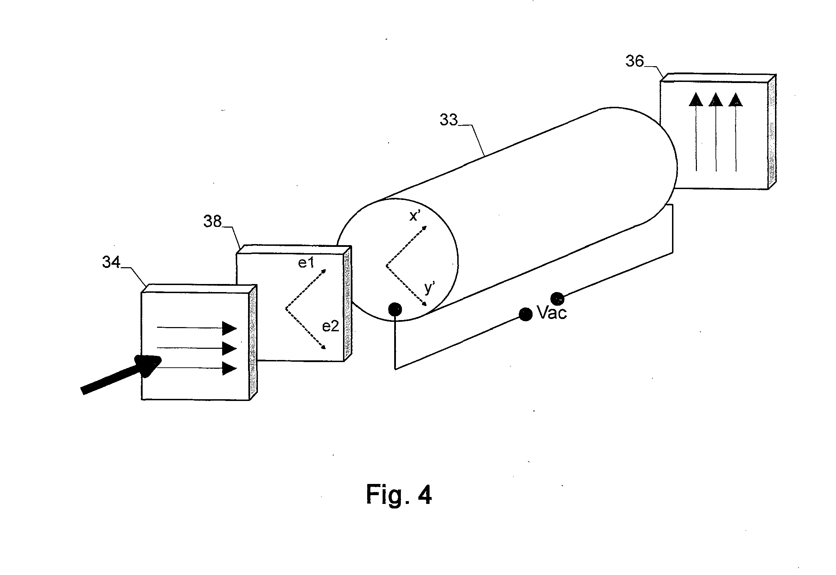

One configuration of a field sensor 6 which implements line integration of the electric field is shown in Fig. 4: The voltage is applied to the end faces of a crystal 33 with the light also entering and leaving the crystal through the end faces. The crystal material and its axis orientation have to be chosen such that only electric field components $E_z$ (pointing along the cylinder axis z or 8) contribute to the electro-optic phase shift [1, 3]. One suitable material is $Bi_4Ge_3O_{12}$ (BGO) in a [001] configuration, corresponding to the 4-fold crystal axis being parallel to the direction of light propagation.

The input light (heavy arrow) is linearly polarized by a first polarizer 34 (arrows indicate direction of transmitted polarization; the polarizer may be an in-fiber polarizer as well). To achieve maximum modulation contrast, the electro-optic axes of the crystal x', y' are preferably oriented under an angle of 45° with respect to the incoming linear polarized light. The phase shift Γ caused by the electric field is converted to an amplitude modulation of the light by a second polarizer 36 placed at the output end of the crystal. To bias the phase retardation, a retarder 38 may be placed into the beam path (between the two polarizers 34, 36), which adds an additional phase shift ϕ. The principal retarder axes, e1 and e2, are aligned parallel to the electro-optic axes, x' and y'.

In general the intensity I of the transmitted light is given by $I=I_0 \sin^2([\Gamma + \phi]/2)$. In the case of a λ/4-waveplate used as retarder 38 this becomes

$$ I = I_0 \sin^2\left( \frac{\pi}{2} \frac{V}{V_\pi} + \frac{\pi}{4} \right) $$

with the half-wave voltage

$$ V_\pi = \frac{\lambda_0}{2 n_0^3 r} $$

For abs($V$) << $V_\pi/2$ the intensity then changes linearly with the voltage. Here V is the voltage applied to the crystal, λ is the wavelength of the light, no is the refractive index of the crystal, and r is the relevant Pockels coefficient. For BGO $V_\pi$ is about 75 kV at a wavelength of 1310 nm.

b) Generation of quadrature signals

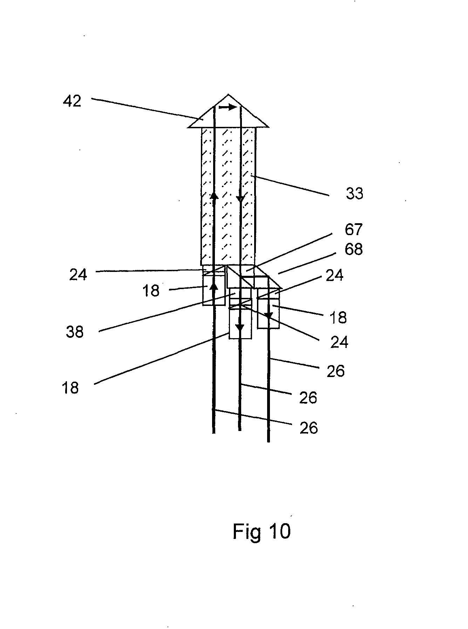

For typical voltages at high-voltage substations, the voltage V is much larger than the half-wave voltage $V_\pi$, which results in an ambiguous sensor response. This ambiguity may be removed by working with two optical output channels that are substantially 90° (π/2) out of phase (in quadrature) [11], or that have any other mutual phase shift that is not a multiple of π. The 90°- phase shift may be generated by splitting the light leaving the crystal into two paths by means of a beam splitter 67 and a deflection prism 68 and putting a quarter-wave plate 38 into one of the paths (Fig. 10) [3]. Further modifications are illustrated in [3]. Fig. 10 shows an arrangement where the sensor is operated in a reflective mode. Alternatively, the sensor may be operated in transmission, i.e. the optics for the generation of the quadrature signals is then arranged at the opposite crystal face so that the light passes the crystal only once.

Another option to remove the ambiguity is to operate the sensor with light of two different wavelengths [12].

In the sensor according to the present invention containing two or more crystals, such as in the assembly of Figs. 2b, 2c or 3, a quadrature signal may also be generated by inserting a phase retarder 38 into the optical path at one of the crystals and operating the other crystals without a retarder, i.e. there is only one output channel per crystal (Fig. 4). Extra beam splitters and deflection prisms for a second channel as needed in [3] are thus avoided. As a result the device becomes significantly smaller, which allows to mount the sensing elements in a relatively narrow bore.

Preferably, the assembly is designed such that the voltage drops at each sensing element are the same. The signals from the individual crystals have then, as a function of the overall voltage, the same periodicity. In cases where the relative voltage drops at the various sensing elements may substantially vary due to environment perturbations of the electric field distribution, it may be of advantage with regard to the signal processing to generate two signals at quadrature from each individual sensor element (arrangement of Fig. 10). The periodicity of the two signals and their phase difference then remains constant (apart from the temperature dependence of the retarder) and is not affected by the field distribution.

Alternatively, the assembly may be designed such that the voltage drops over the different crystals differ. In this case the optical signals from the individual crystals have different periodicity. With appropriate signal processing this also allows to unambiguously reconstruct the applied voltage.

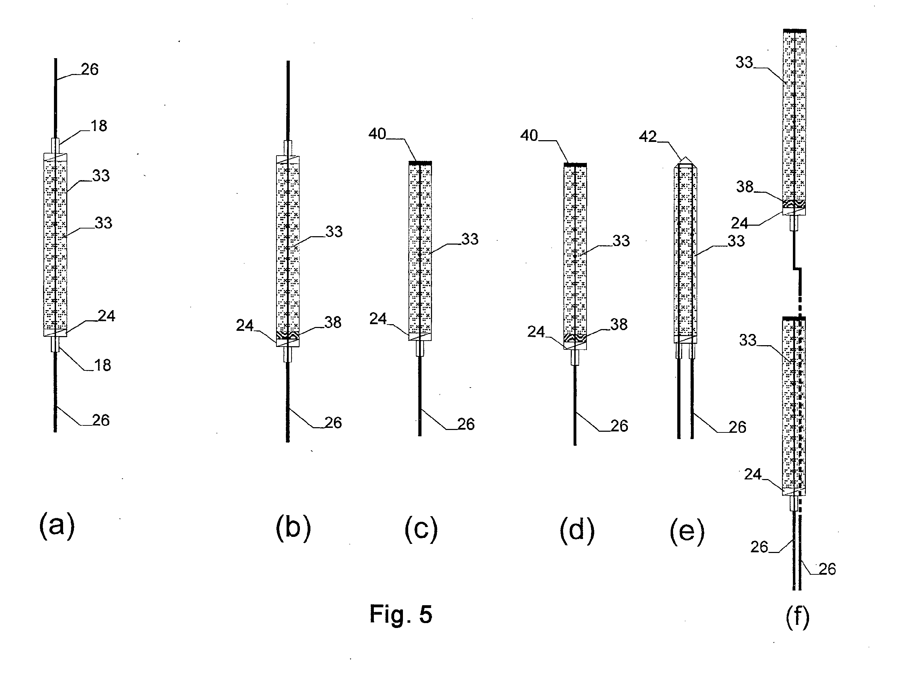

Fig. 5 shows the optical components in more detail. The components (polarizers, waveplate, fiber pig-tailed collimators) are advantageously directly attached to the crystal, e.g. by an optical adhesive. The assembly of Fig. 5a is without a retarder while the assembly of Fig. 5b is with a retarder 38, in particular a quarter-wave retarder, to generate a quadrature signal.

In Fig 5a, 5b the crystals are operated in transmission. Alternatively only one fiber 26 may be used to guide the light to and from the crystal 33 as shown in Fig. 5c, 5d. In this case a reflector 40 at the other end of the crystal is used to direct the light back into the fiber. This configuration doubles the sensitivity of the sensing element. As a result of the double pass a $\pi/8$ retarder 38 is now advantageously used to generate a quadrature signal.

A reflective configuration may also be realized with two individual fibers 36 for light input and output light and a prism reflector 42 as shown in Fig. 5e.

Turning back to the configuration where an assembly comprising several field sensors is used, it has been mentioned that a retarder 38, in particular a $\lambda/4$ retarder, can be attributed to one of them, or, more generally, only to a subset (i.e. not all) of them, for adding an additional phase retardation to the light passing through the respective field sensor(s), which can then be used for quadrature demodulation. This is schematically depicted in Fig. 5(f).

Alternatively (or in addition) to adding one or more retarder(s) to such an assembly, it is possible to dimension at least one (or a subset) of the field sensors such that it generates an electro-optic phase shift that is substantially different from the phase shifts of the remaining field sensors, in particular of $\pm\pi/2$ or less at the maximum voltage to be measured. The respective field sensor(s) may e.g. be shorter than the other field sensor(s). In that case the signal of the respective field sensor(s) is unambiguous, which allows to correct for ambiguities in the (more accurate) signals of the other field sensor(s).

c) Sensor interrogation

The light is guided to and from the individual crystals by means of single or multimode optical fibers [3]. The fibers may be embedded in the silicone filling inside bore 5 of the epoxy rods. The crystals may be operated in transmission or in reflection [3], as illustrated in Figs. 5 and Fig. 10.

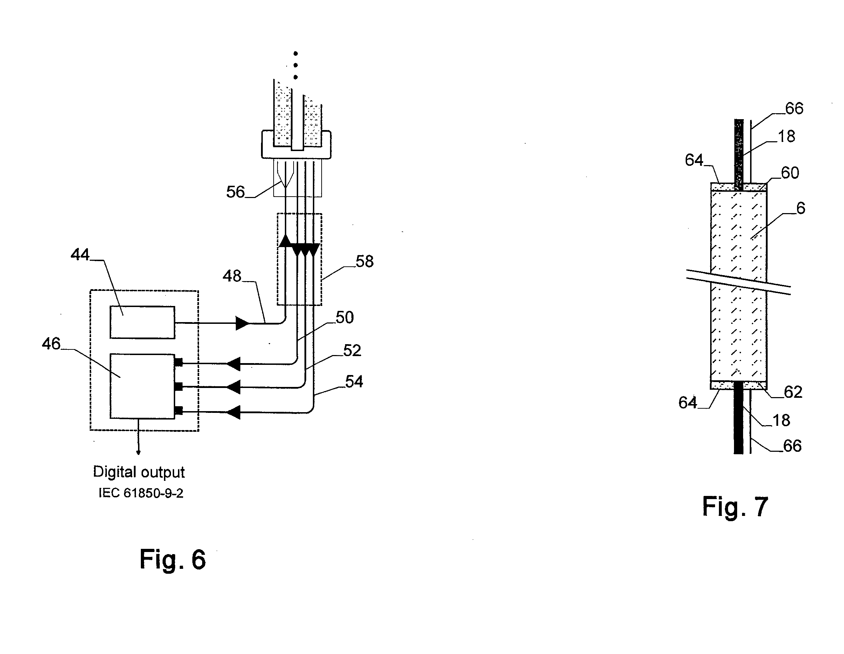

In an arrangement comprising several voltage sensors in series, the field sensors 6 are preferably interrogated using a common light source 44 and signal processing unit 46 as shown in Fig. 6. Advantageously, the light from light source 44 is transmitted by a single fiber link 48 to the base of the sensor (this sensor end is at ground potential). Then the light is distributed to the individual field sensors 6 by a means of a fiber-optic beam splitter 56. The light is returned from each field sensor 6 to signal processor unit 46 by individual fiber links 50, 52, 54. All fibers (input and output) may be embedded in a common fiber cable 58.

Alternatively, the opto-electronics module may be mounted directly at the base of the sensor to avoid long fiber cables. Additionally, the opto-electronics module may be equipped with means for active or passive temperature control.

*Temperature compensation*

The phase shift introduced by retarder 38 typically is a function of temperature. Therefore the temperature at the location of the retarder can be extracted in the signal processor from two of the above mentioned quadrature signals, as is also mentioned in [3]. The temperature information can then be used to compensate for any temperature dependence of the voltage measurement. Commonly, the retarder temperature can be considered as a sufficiently good approximation of the overall temperature of the voltage sensor. The temperature dependence of the voltage measurement may be composed of several contributions: the temperature dependence of the electro-optic effect and additionally, in case of local field sensors, contributions from the temperature dependence of the dielectric constants of the sensor material and surrounding materials as well from changes in the local electric field strength due to the thermal expansion of the insulator 1 with embedded electrodes.

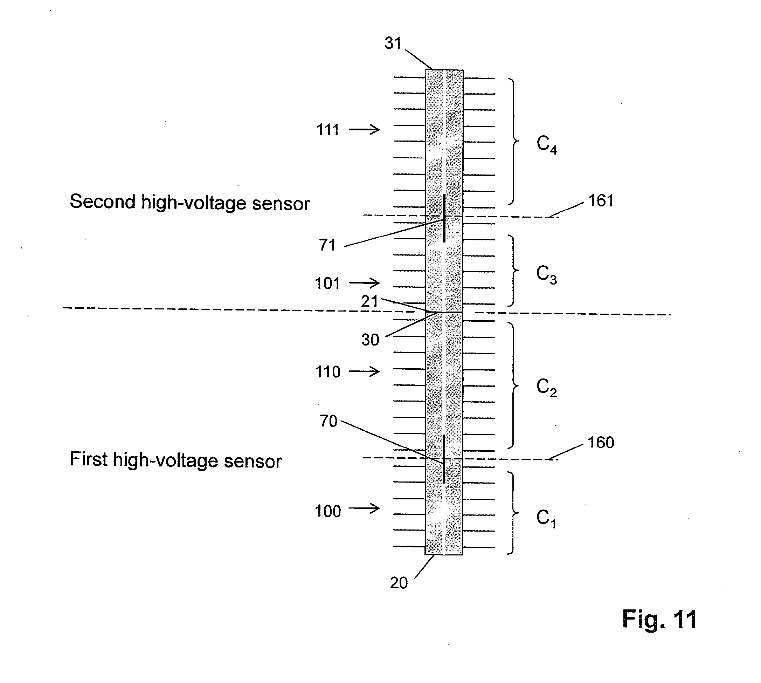

In the following further examples and embodiments are discussed, in particular in connection with Fig. 11 - 13.

*Optimization of electric field distribution and voltage drop across sensors modules*

In Fig. 11 an exemplary configuration of an assembly of high-voltage sensors is shown which consists of a serial arrangement of at least two high-voltage sensors with identical electrode dimensions. The first primary electrode $E1_1$ of the second high-voltage sensor is connected to high potential and the second primary electrode $E2_2$ of the first high-voltage sensor connected to the ground potential (not shown). The second primary electrode $E2_1$ of the second high-voltage sensor is connected to the first primary electrode $E1_2$ of the first high-voltage sensor, such that the two electrodes are at the same potential. The electric field boundary conditions found in a typical substation environment, for example comprising neighboring phases, result in an unequal distribution of the voltages between the two high-voltage sensors. Similarly, the voltages are unequally distributed between the sets of electrodes arranged in the first regions 100, 101 with respect to the second regions 110, 111 in either one of the high-voltage sensors forming the assembly. This unequal distribution of the voltage generates enhanced electric field stress at certain locations of the high-voltage sensors, in particular in the bottom section 101 of the second high-voltage sensor. To compensate for this effect, the capacitances of the sets of electrodes in the first regions 100, 101 and the second regions 110, 111 of each high-voltage sensor can be made different, thus making the design of the high-voltage sensor asymmetric with respect to the measurement cavities 70 and 71, respectively. A useful way is to choose the axial length of the electrodes in the first regions 100, 101 to be longer than the electrodes in the second regions 110, 111. In exemplary configurations the capacitances $C_1$, $C_2$ and $C_3$, $C_4$ of the sets of the electrodes in the first and second regions 100, 110 and 101, 111, respectively, of the two high-voltage sensors can be chosen such that $C_1=C_3$ and $C_2=C_4$, and in particular with a ratio of $C_1/C_2$ being in the range of 1.1 to 1.5.

Preferably, the radial dimensions of the electrodes in the first 100 and second region 110 of the first high-voltage sensor and in the first 101 and second region 111 of the second high-voltage sensor are the same.

Alternative ways to optimize the capacitance of the field steering structure are:

- Variation of the grading distance, e.g. B1i $\neq$ B2i or C1i $\neq$ C2i (refer to Fig. 1);
- Different number of electrodes in the first and second region 10, 11; 100, 101; 110, 111 of the high-voltage sensor or assembly of high-voltage sensors;
- Different radial spacings, e.g. distance P between electrodes being different in the first and second region 10, 11; 100, 101; 110, 111 of the high-voltage sensor or assembly of high-voltage sensors;
- Connecting selected neighboring electrodes electrically to effectively short-circuiting them;
- Changing the dielectric constant of the material between the electrodes; in particular, materials with high dielectric constant could be used to increase the capacitances and hence reduce the effect of unequal voltage distribution.

In general, it would be beneficial to choose the capacitance for the high-voltage sensors to be much larger in comparison to any stray capacitance. This will decouple the field distribution inside the sensing cavity from outside influences. For example, a material between the electrodes with high dielectric constant could be used to increase the capacitance and hence reduce the effect of unequal voltage distribution.

Alternatively or in addition, the shape of the metal contacts 4 connected to the electrodes can be chosen such that the effect of the stray capacitances on the voltage distribution is minimized. For example, the metal contact connected to the first primary electrode of the second high-voltage sensor could be designed with its diameter significantly larger than the diameters of all electrodes of that high-voltage sensor. In this way it would serve two functions: In addition to its mechanical purpose, in particular mounting fixture and sealing the top, it could be used for adjusting the stray capacitance.

*Electrodes attached to sensor crystal*

The preferred embodiment of the field sensor is an electro-optic crystal which is equipped with electrically conducting electrodes at both of its ends. Embodiments of such contacting electrodes 64 are shown in Fig. 12, wherein 640 designates a front part of the contacting electrode, 641 a flexible connection, 642 a front cavity of the contacting electrode, 643 a back part of the contacting electrode, 644 a sealing of the contacting electrode, 645 a back volume or internal volume of the contacting electrode, 648 centering pin(s), and 480 optical fibers or optical cables.

In embodiments these contacting electrodes 64 can have the following features (each feature alone or in any combination with other features):

- The electrode is connected to the respective electric potential, i.e. to the innermost electrodes (electrode $E1_1$ or $E2_1$) by means of an electrical connection 66, preferably a metal wire 66 running back to metal contact 4;
- The connection between sensor crystal 33 and contacting electrode 64 is done in a flexible manner to avoid mechanical stress on the crystal 33, for example due to different thermal expansion of crystal 33 and electrode 64.

Suitable materials are for example rubber o-rings or silicone; as an alternative the electrode 64 itself or its front part 640 could be fabricated from an elastic material, e.g. electrically conductive rubber or other elastomer;

- The front part 640 of the contacting electrode 64 can have a rounded shape which minimizes the electric field stress at the surface of the contacting electrode 64. The axial distance between the front part 640 of the electrode 64 and the front surface of the flexible connection 641 of the crystal 33 to the contacting electrode 64 is chosen sufficiently large so that electrical discharges in any of the materials and in particular at any material interfaces neighbouring the flexible connection 641 are avoided;

- Suitable materials for the contacting electrode 64 are electrically conducting materials, e.g. metals and alloys like aluminum alloys and stainless steels; advantageously, complex shaped electrodes 64 would be fabricated in a molding process in order to achieve low cost; in particular, polymeric materials and polymer-based composites can be used for molding, like e.g. electrically conductive thermoplastic or thermoset materials;

- The electrode may have a front cavity 642, as depicted in Fig. 12, in order to allow the filler material, for example compressible silicone or polyurethane foam, to properly fill any space containing high electric fields, for example in the gap between contacting electrode 64 or front part 640 and sensor crystal 33; with the filler material being inserted at an overpressure, the remaining air will be compressed into the field free space inside this front cavity 642 which is free from electric fields and thus free from risk of electric discharges in air pockets formed during the filling process;

- The contacting electrode 64 may be equipped with centering pins 648 protruding from it radially to position the sensor crystal 33 in the center of the bore 5;

- The sealed contacting electrode 64, in particular its back part 643, is used to protect the optics assembly 180 from exposure to the filler material, like e.g. silicone elastomer; additionally, the internal volume 645 of the contacting electrode 64 may be filled with special material for protection of the optics assembly 180, e.g. like dry $N_2$ gas.

*Fiber handling and Return fiber*

Figure 3(a) shows one possibility for handling of the return fiber 27, wherein the return fiber 27 is running through the sensing cavity 7 in the central bore 5 right next to the sensor element 6. In this configuration the return fiber 27 will be embedded in the filler material to guarantee sufficient dielectric strength.

Alternative embodiments for mounting the return fiber 27 are:

- As shown in Fig 2(c), at least one sensor module 1 may be placed inside a hollow-core insulator 25 consisting of a fiber reinforced epoxy tube and having an external shed insulator 19, preferably made of silicone elastomer, on the outside of the tube; the gap between the insulator 1 and the hollow-core insulator 25 may be filled for example with polyurethane foam; because the field strength in this gap is much smaller than the field strength in the sensing cavity 7, it would be beneficial to mount the return fiber 27 inside this gap;

- Alternatively, the external silicone sheds 19 could be directly molded onto the outside of the insulator 1 . The return fiber 27 could be mounted in a helical-shaped groove at the outside of the insulator 1. Here the fiber 27 can be over-molded by the silicone sheds 19 ;

- Alternatively, the return fiber 27 could be embedded into a resin impregnated paper (RIP) body of the insulator 1 during winding.

These ways to mount an optical fiber are not limited to the return fiber 27 only. There may be additional optical fibers mounted in the sensor module:

- For serial installation of several modules, e.g. two modules as shown in Fig 11, one or more fibers, e.g. 26 in Fig. 3 (a), passing through the bottom module(s) would be needed to optically connect the module(s) further up; preferably, the interconnection of optical fibers in adjacent modules would be done by means of optical splices; the optical splices should be placed inside a hollow volume in the structure, for example a flange, used for making the mechanical connection between the modules; alternatively or in addition, the mechanical connection could be equipped with a lateral opening which would allow access to the fibers and optical splicing after mechanically connecting the modules;

- Optical fibers might be needed to make connection to other types of sensors mounted on the top of the voltage sensor, e.g. like an optical current sensor;

- Various fiber types could be used at different locations, i.e. the optical fibers could be single-mode fibers, multi-mode fibers, or polarization maintaining fibers.

*Manufacturing of the high-voltage sensor*

In its simplest form the high-voltage sensor has a cylindrical shape with a constant outer diameter along its entire length, as shown in Fig 2(a). In order to save material and reduce cost it is beneficial to optimize the outside shape.

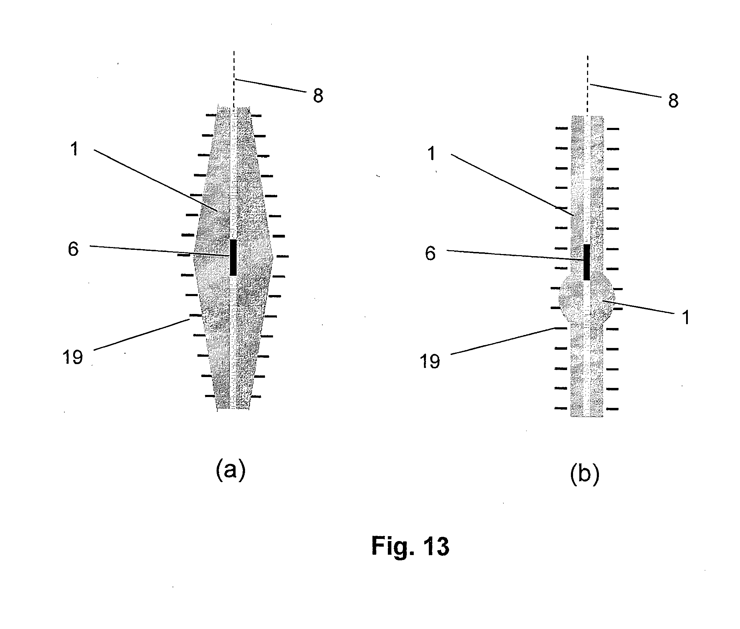

In embodiments, the diameter of the high-voltage sensor can be bigger at locations of high electric field strength, whereas a smaller diameter can be used at locations where the field strength is low. Possible configurations are shown in Fig 13. In a particularly advantageous design in Fig 13(b) the diameter of the high-voltage sensor is increased around the end position of the shield electrode $E_s$ (not shown) facing the bottom end of the high-voltage sensor where the axial electric field strengths on the insulator surface is the highest. Alternatively, a locally increased diameter can be positioned at several different points of the sensors length.

*Notes*

When using electro-optical crystals as field sensors, several (or all) crystals may be interrogated by one light beam which traverses the crystals one after the other. This could for example be achieved by either shining a free space beam through all crystals (with the crystal axes properly aligned) or by interconnecting adjacent crystals with a polarization-maintaining fiber. The birefringent fiber axes are then aligned parallel to the electro-optic axes of the crystals.

Instead of bulk electro-optic crystals, electro-optic waveguide structures may be used [13].

The voltage sensor can also be used with other types of field sensors, such as piezo-optical sensors based on quartz crystals [6] or sensors based on poled waveguides, such as poled fibers [14].

As mentioned, the electrodes are advantageously metal foils embedded within insulating insulator 1 with longitudinal dimensions selected such that a voltage applied to the ends of insulator 1 homogeneously drops over the length of the field sensor inside the sensing cavity 7 and over the full length of insulator 1 at its outer surface. Excessive peak electric fields are avoided.

Optionally, and as schematically depicted in Fig. 7, the first and second ends 60, 62 of field sensor 6 can be electrically contacted to the first and second contact points 2, 3, respectively, e.g. by means of metal electrodes 64 or optically transparent conductive coatings (such as indium tin oxide layers) at the ends 60, 62 and wires 66 leading through bore 5. This design further improves measurement accuracy because it ensures that the ends 60, 62 of field sensor 6 are at the potentials of the two contact points 2, 3, respectively.

In general terms and in an advantageous embodiment, the voltage sensor comprises an insulator 1 with mutually insulated electrodes Eij, $E_s$ embedded therein. The electrodes are coaxial and cylindrical and overlap axially over part of their lengths. They are mutually staggered and guide the homogeneous field outside the sensor to a substantially homogeneous but higher field within the sensing cavity 7 within the insulator 1. A field sensor 6 is arranged within the sensing cavity 7 to measure the field. This design allows to produce compact voltage sensors for high voltage applications.

All appended claims 1 to 36 are herewith literally and in their entirety incorporated into the patent description by way of reference.

<u>References</u>

1. L. Duvillaret, S. Rialland, and J.-L. Coutaz "Electro-optic sensors for electric field measurements. II. Choice of the crystal and complete optimization of their orientation" J. Opt. Soc. Am. B 19 2704 (2002)

2. US 4,904,931

3. US 5,715,058

4. US 6,252,388

5. US 6,380,725

6. US 6,140,810

7. US 6,876,188

8. US 3,875,327

9. US 4,362,897

10. EP 1 939 897 A1

11. US 5,001,419

12. WO 98/05975

13. US 5,029,273 and N.A.F. Jaeger et al., IEEE Trans. Power Deliv. 10 127 (1995)

14. US 5,936,395 and US 6,348,786

15. EP 0 789 245 A2

16. K. Bohnert et al., Optical Engineering, 39 (11), 3060 (2000).

17. Standard of the International Electrotechnical Commission IEC60044-7, Instrument transformer - Part 7 : Electronic voltage transformers.

Reference numbers

**[0108]**

| 1: | insulator |
|---|---|
| 2, 3; 20, 30; 21, 31: | contact points |
| 4: | metal contacts |
| 5: | bore |
| 6: | field sensor |
| 7; 70, 71: | sensing cavity8: longitudinal axis |
| 10, 11; 100, 110; 101, 111: | first and second region |
| 14: | central end of electrode |
| 15: | contact end of electrode |
| 16, 160, 161: | reference plane |
| 18, 180: | collimator, optics assembly |
| 19: | sheds |
| 25: | hollow core high-voltage insulator, outer insulator, external insulator |
| 22: | support tube |
| 24: | braces |
| 26: | fibers |
| 27: | return fiber |
| 28: | strain reliefs |
| 35: | joints |
| 32: | spacer tubes |
| 33: | crystal, sensing element |
| 340: | optics, optics assembly |
| 34, 36: | polarizers |
| 38: | retarder |
| 40: | reflector |
| 42: | prism reflector |
| 44: | light source |
| 46: | signal processing unit |
| 480: | optical fiber cable(s) |
| 48, 50, 52, 54: | fiber link |
| 56: | beam splitter |
| 58: | fiber cable |
| 60, 62: | ends of field sensor |
| 64: | metal electrodes, conductive coatings, contacting electrode |
| 640: | front part of contacting electrode |
| 641: | flexible connection |
| 642: | front cavity of contacting electrode |
| 643: | back part of contacting electrode |
| 644: | sealing of contacting electrode |
| 645: | back volume of contacting electrode, internal volume of contacting electrode |
| 648: | centering pin(s) |
| 66: | wires |
| 67: | beam-splitter |
| 68: | deflection prism |

| $a$, $B_{ij}$, $C_{ij}$: | axial distances |
|---|---|
| $C_1$, $C_2$, $C_3$, $C_4$: | capacitances |
| P: | radial distances |
| $E_{ij}$, $E_s$: | electrodes |
| L: | length of insulator |
| 1: | length of crystal |
| D: | diameter of insulator |
| d: | diameter of crystal |
| e: | diameter of bore |

## EP 2 577 328 B1

**Claims**

1. A high-voltage sensor for measuring a voltage between a first and a second contact point (2, 3, 20, 30, 21, 31) comprising

   an insulator (1) of an insulating material extending along an axial direction between the first and the second contact points (2, 3, 20, 30, 21, 31),

   a plurality of conductive electrodes ($Ei_j$, $E_s$) arranged in said insulator (1), wherein said electrodes ($Ei_j$, $E_s$) are mutually separated by said insulating material and capacitively coupled to each other,

   at least one electric field sensor (6) arranged in at least one sensing cavity (7; 70, 71), in particular in exactly one sensing cavity (7), of said insulator (1),

   wherein, for at least part of said electrodes ($Ei_j$, $E_s$), each electrode axially overlaps at least another one of said electrodes ($Ei_j$, $Es$),

   wherein said electrodes ($Ei_j$, $Es$) are arranged for generating an electric field in said sensing cavity (7; 70, 71) having a mean field strength larger than said voltage divided by a distance between said first and said second contact point (2, 3, 20, 30, 21, 31), and

   the high-voltage sensor comprising at least a first primary electrode ($E1_1$) electrically connected to the first contact point (2; 20, 21) and a second primary electrode ($E2_1$) electrically connected to the second contact point (3; 30, 31) and wherein said electrodes ($Ei_j$, $E_s$) form a capacitive voltage divider between the first and the second primary electrodes ($E1_1$, $E2_1$).

2. The high-voltage sensor of claim 1, wherein at least one of said electrodes ($Ei_j$, $E_s$) is a shield electrode ($E_s$) radially surrounding said sensing cavity (7; 70, 71), in particular wherein an outer diameter of the high-voltage sensor is enlarged at axial locations having high or above-average electric field strength and is reduced at axial locations having low or below-average electric field strength, further in particular wherein the diameter is increased around an axial bottom end position of the shield electrode ($E_s$).

3. The high-voltage sensor of any of the preceding claims, wherein said field sensor (6) axially overlaps with said first primary electrode ($E1_1$) as well as with said second primary electrode ($E2_1$), and in particular wherein said electric field sensor (6) measures the line integral of the field over a length 1 of said field sensor (6), or wherein said at least one electric field sensor (6) is a local electric field sensor that measures said field over only part of an axial extension of the sensing cavity.

4. The high-voltage sensor of any of the preceding claims, wherein for each sensing cavity (7; 70, 71) said electrodes ($Ei_j$, $E_s$) comprise a first set of electrodes $E1_i$ with i = 1 .. N1 and a second set of electrodes $E2_i$ with i = 1 .. N2, with the electrodes $E1_i$ of the first set being arranged in a first region (10) of said insulator (1), which first region (10; 100, 101) extends from a reference plane (16; 160, 161) of said sensing cavity (7; 70, 71) to said first contact point (2; 20, 21), and with the electrodes $E2_i$ of the second set being arranged in a second region (11; 110, 111) of said insulator (1), which second region (11; 110, 111) extends from said reference plane (16; 160, 161) to said second contact point (3; 30, 31), wherein said reference plane (16; 160, 161) extends radially through said sensing cavity (7; 70, 71), in particular N1 = N2, and in particular wherein a first electrode $E1_1$ of said first set forms said first primary electrode and a first electrode $E2_1$ of said second set forms said second primary electrodes.

5. The high-voltage sensor of claim 4, wherein, for each set j of electrodes, the electrodes $Ej_i$ and $Ej_{i+1}$ axially overlap along an overlapping section, wherein, in said overlapping section, the electrode $Ej_{i+1}$ is arranged radially outside from the electrode $Ej_i$.

6. The high-voltage sensor of any of the claims 4 to 5, wherein, for each set j of electrodes,

   each electrode has a center end (14) facing said reference plane (16; 160, 161) and a contact end (15) axially opposite to said center end (14),

   the center end (14) of the electrode $Ej_{i+1}$ is closer to said reference plane (16; 160, 161) than the center end (14) of the electrode $Ej_i$, and the contact end (15) of the electrode $Ej_{i+1}$ is closer to said reference plane (16; 160, 161) than the contact end (15) of the electrode $Ej_i$,

   the center end (14) of the electrode $Eji_{+1}$ has an axial distance $Bj_i$ from the center end (15) of the electrode $Ej_i$, and the contact end (14) of the electrode $Ej_{i+1}$ has an axial distance $Cj_i$ from the contact end (14) of the electrode $Ej_i$, and

   the electrodes $Ej_i$ and $Ej_{i+1}$ axially overlap between the contact end (15) of the electrode $Ej_{i+1}$ and the center end (14) of the electrode $Ej_i$.

7. The high-voltage sensor of claim 6, wherein, for each set j of electrodes, the axial distance $Bj_i$ is smaller than the

**15**

axial distance $Cj_i$, and/or wherein each set j of electrodes has a different i-th axial distance $Bj_i$ (e.g. $B1_i \neq B2_i$) and/or a different i-th axial distance $C1_i$ (e.g. $C1_i \neq C2_i$).

8. The high-voltage sensor of any of the claims 6 to 7, wherein, for each set j of electrodes, the axial distances $Bj_i$ are substantially equal to a common distance B and/or the axial distances $Cj_i$ are substantially equal to a common distance C.

9. The high-voltage sensor of any of the claims 4 to 8 and of claim 2, wherein said shield electrode ($E_s$) axially overlaps with at least one electrode of said first set and at least one electrode of said second set,
and in particular wherein the shield electrode ($E_s$) axially overlaps with a radially outmost electrode ($E1_6$) of said first set and a radially outmost electrode ($E2_6$) of said second set and is arranged radially outside from said outmost electrodes ($E1_6$, $E2_6$) of said first and said second sets.

10. The high-voltage sensor of any of the claims 4 to 9, wherein said electrodes are arranged non-symmetrically with respect to the reference plane (16, 160, 161), and/or wherein said electrodes are embedded in insulator material comprising different dielectric constants on either side of the reference plane (16, 160, 161).

11. The high-voltage sensor of any of the claims 4 to 10, wherein for at least one sensing cavity (7; 70, 71) the first set of electrodes $E1_i$ forms a first capacitance ($C_1$, $C_3$) and the second set of electrodes $E2_i$ forms a second capacitance ($C_2$, $C_4$), and in particular wherein the first capacitance ($C_1$, $C_3$) and the second capacitance ($C_2$, $C_4$) is made larger than any stray capacitance present in a mounted state of the high-voltage sensor and/or wherein a ratio of the first and second capacitance ($C_1/C_2$, $C_3/C_4$) is in the range of 1.1 to 1.5.

12. The high-voltage sensor of claim 11, wherein for increasing the first capacitance ($C_1$, $C_3$) over the second capacitance ($C_2$, $C_4$) :

the first set of electrodes $E1_i$ comprises or consists of i-th electrodes $E1_i$ having longer axial lengths than the i-th electrodes $E2_i$ of the second set; and/or the first set of electrodes $E1_i$ comprises a different number of electrodes than the second set of electrodes $E2_i$; and/or the first set of electrodes $E1_i$ comprises a different spacing (P) between the electrodes $E1_i$ compared to the second set of electrodes $E2_i$; and/or selected neighbouring electrodes in the first and/or second set are electrically short-circuited; and/or the first set of electrodes $E1_i$ comprises insulation material of higher dielectric constant than the second set of electrodes $E2_i$.

13. The high-voltage sensor of any of the claims 4 to 9, wherein the electrodes $E1_i$ of said first set are equally spaced in radial direction and wherein the electrodes $E2_i$ of said second set are equally spaced in radial direction, and/or wherein said electrodes are arranged symmetrically in respect to a reference plane (16; 160, 161) extending radially through said sensing cavity (7; 70, 71), and/or wherein at least part, in particular all, of said electrodes ($Ej_i$, $E_s$) are substantially cylindrical and/or coaxial to each other.

14. The high-voltage sensor of any of the preceding claims, wherein said field sensor (6) is an optical sensor introducing a field-dependent phase shift between a first polarisation or mode and a second polarization or mode of light passing through it, and in particular wherein said optical sensor comprises
an electro-optical device with field-dependent birefringence, in particular a crystal, in particular of crystalline $Bi_4Ge_3O_{12}$ (BGO) or $Bi_4Si_3O_{12}$ (BSO), or a poled waveguide exhibiting a Pockels effect, or
a piezo-electric device, in particular of crystalline quartz or a piezoelectric ceramic, and a waveguide carrying at least two modes, wherein said waveguide is connected to said piezo-electric device thus that a length of said waveguide is field-dependent.

15. The high-voltage sensor of claim 14, wherein said field sensor (6) has two optical output channels having a mutual phase shift that is not a multiple of $\pi$, and in particular that is a mutual phase shift of substantially $\pi/2$.

16. The high-voltage sensor of any of the preceding claims, wherein a first end (60) of said field sensor (6) has a contacting electrode (64) that is electrically connected, in particular via a wire (66), to said first contact point (2; 20, 21), and a second end (62) of said field sensor (6) has another contacting electrode (64) that is electrically connected, in particular via a wire (66), to said second contact point (3; 30, 31),
in particular wherein at least one of the contacting electrodes (64) comprises a front part (640) for accommodating a flexible connection (641), in particular a rubber o-ring or silicone, to the electric field sensor (6), and/or wherein the front part (640) has rounded edges for minimizing electric field stress at the end (60, 62) of the electric field sensor (6) and provides a field-free cavity (642) as an air release volume (642) during an embedding procedure of the electric field sensor (6) in the insulating material, in particular in compressible silicone or polyurethane foam, or in particular wherein at least one of the contacting electrodes (64) comprises centering pins (648) for radially centering the electric field sensor (6) in a bore (5) of the high-voltage sensor, and/or wherein at least one of the contacting electrodes (64) is fabricated from an elastic material, such as electrically conductive rubber or elastomer, or from an electrically conductive mouldable polymeric material, such as electrically conductive thermoplastic or thermoset material.

17. The high-voltage sensor of claim 16, wherein at least one of the contacting electrodes (64) comprises a back part (643) that provides an internal volume (645) for accommodating an optics assembly (180) for optically connecting the field sensor (6) to an optical cable (480), and in particular wherein the internal volume (645) has a sealing (644) and/or a filling substance for protecting the optics assembly (180) against exposure to the insulating material.

18. The high-voltage sensor of any of the preceding claims, wherein the insulator (1) comprises a solid, liquid, gas, or vacuum and, in particular, wherein the insulator (1) is placed inside a hollow-core high-voltage outer insulator (25), preferably made of fiber reinforced epoxy tube, with an external shed insulator (19), preferably made of silicone elastomer, for accommodating in its hollow core the insulator (1), which comprises the sensing cavity (7; 70, 71), and a gap externally of the insulator (1) for receiving optical fibers, such as a return fiber (27) or a transmission fiber (26) for optically connecting further sensor module bodies or other optical sensors, and with the gap being filled, in particular with polyurethane foam,
and/or wherein optical fibers, such as a return fiber (27) or a transmission fiber (26) for optically connecting further sensor module bodies or other optical sensors, are mounted inside a bore (5) of the insulator (1), which comprises the sensing cavity (7; 70, 71), and with the bore (5) being filled, in particular with compressible silicone,
and/or wherein the insulator (1), which comprises the sensing cavity (7; 70, 71), has a helical-shaped groove at its outside, and optical fibers, such as a return fiber (27) or a transmission fiber (26) for optically connecting further sensor module bodies or other optical sensors, are mounted in the groove and are over-moulded, preferably by silicone, to form an external shed insulator 19 directly onto the insulator (1),
and/or wherein the insulator (1), which comprises the sensing cavity (7; 70, 71), is made out of resin-impregnated paper or fiber insulation, and optical fibers, such as a return fiber (27) or a transmission fiber (26) for optically connecting further sensor module bodies or other optical sensors, are embedded into the resin-impregnated paper or fiber insulation during winding.

19. An assembly of several, in particular identical, high-voltage sensors of any of the preceding claims arranged in series.

20. The assembly of claim 19 with several high voltage sensors of claim 15, wherein an optical retarder (38), in particular a $\lambda/4$ retarder, is attributed to only a subset of the field sensors (6), for adding an additional phase retardation to light passing through the field sensor (6),
and/or wherein a subset of said field sensors (6), in particular one of said field sensors (6), are or is dimensioned to generate a phase shift that is substantially different from the phase shifts of the remaining field sensors (6), in particular a phase shift of $\pm\pi/2$ or less at a maximum voltage to be measured of said assembly,
and/or wherein only a subset of high-voltage sensors is equipped with a field sensor.

21. The assembly of any of the claims 19 to 20, wherein the contact points (2, 3, 20, 30, 21, 31) are equipped with metal contacts (4), and the high-voltage-side uppermost metal contact (4) of the assembly has the largest diameter of all metal contacts (4),
and/or wherein optical splices for optical fibers are placed inside a hollow volume in a mechanical connection between neighbouring high-voltage sensors, and in particular wherein a lateral opening is provided in the mechanical connector for giving access to the optical fibers and for splicing the optical fibers.

**Patentansprüche**

1. Hochspannungssensor zum Messen einer Spannung zwischen einem ersten und einem zweiten Kontaktpunkt (2, 3, 20, 30, 21, 31), umfassend
einen Isolator (1) aus einem isolierenden Material, der sich entlang einer axialen Richtung zwischen dem ersten und zweiten Kontaktpunkt (2, 3, 20, 30, 21, 31) erstreckt,
mehrere leitfähige Elektroden ($Ei_j$, Es), die im Isolator (1) angeordnet sind, wobei die Elektroden ($Ei_j$, Es) wechselseitig durch das isolierende Material getrennt sind und kapazitiv miteinander gekoppelt sind,

mindestens ein elektrischer Feldsensor (6), der in mindestens einem Sensorhohlraum (7; 70, 71) angeordnet ist, insbesondere in genau einem Sensorhohlraum (7) des Isolators (1),

wobei für mindestens einen Teil der Elektroden ($Ei_j$, $E_s$) jede Elektrode mindestens eine andere der Elektroden ($Ei_j$, $E_s$) axial überlappt,

wobei die Elektroden ($Ei_j$, $E_s$) zum Erzeugen eines elektrischen Feldes in dem Sensorhohlraum (7; 70, 71) angeordnet sind, das eine mittlere Feldstärke größer als die Spannung geteilt durch einen Abstand zwischen dem ersten und dem zweiten Kontaktpunkt (2, 3, 20, 30, 21, 31), hat und

der Hochspannungssensor, der mindestens eine erste Primärelektrode ($E1_1$) umfasst, die elektrisch mit dem ersten Kontaktpunkt (2; 20, 21) verbunden ist, und eine zweite Primärelektrode ($E2_1$) umfasst, die elektrisch mit dem zweiten Kontaktpunkt (3; 30, 31) verbunden ist, und wobei die Elektroden ($Ei_j$, $E_s$) einen kapazitiven Spannungsteiler zwischen der ersten und der zweiten primären Elektrode ($E1_1$, $E2_1$) bilden.

2. Hochspannungssensor nach Anspruch 1, wobei mindestens eine der Elektroden ($Ei_j$, $E_s$) eine Schirmelektrode ($E_s$) ist, die den Sensorhohlraum (7; 70, 71) radial umgibt, wobei insbesondere ein Außendurchmesser des Hochspannungssensors an axialen Stellen mit hoher oder überdurchschnittlicher elektrischer Feldstärke erhöht ist und an axialen Stellen mit geringer oder unterdurchschnittlicher elektrischer Feldstärke reduziert ist, wobei ferner insbesondere der Durchmesser um eine axiale untere Bodenendposition der Schildelektrode ($E_s$) erhöht ist.

3. Hochspannungssensor nach einem der vorhergehenden Ansprüche, wobei der Feldsensor (6) sich axial mit der ersten Primärelektrode ($E1_1$) sowie mit der zweiten Primärelektrode ($E2_1$) überlappt, und wobei insbesondere der elektrische Feldsensor (6) das Linienintegral des Feldes über eine Länge l des Feldsensors (6) misst, oder wobei der mindestens eine elektrische Feldsensor (6) ein lokaler elektrischer Feldsensor ist, der das Feld nur über einen Teil einer axialen Ausdehnung des Sensorhohlraums misst.

4. Hochspannungssensor nach einem der vorhergehenden Ansprüche, wobei für jeden Sensorhohlraum (7; 70, 71) die Elektroden ($Ei_j$, $E_s$) einen ersten Satz von Elektroden $E1_i$ mit i = 1 .. N1 und einen zweiten Satz von Elektroden $E2_1$ mit i = 1 .. N2 umfassen, wobei die Elektroden $E1_i$ des ersten Satzes in einem ersten Bereich (10) des Isolators (1) angeordnet sind, wobei dieser erste Bereich (10; 100, 101) sich von einer Referenzebene (16; 160, 161) des Sensorhohlraums (7; 70, 71) bis zum ersten Kontaktpunkt (2; 20, 21) erstreckt, und wobei die Elektroden $E2_i$ des zweiten Satzes in einem zweiten Bereich (11; 110, 111) des Isolators (1) angeordnet sind, wobei der zweite Bereich (11; 110, 111) sich von der Referenzebene (16; 160, 161) bis zum zweiten Kontaktpunkt (3; 30, 31) erstreckt, wobei die Referenzebene (16; 160, 161) sich radial durch den Sensorhohlraum (7; 70, 71) erstreckt, insbesondere ist N1 = N2, und wobei insbesondere eine erste Elektrode $E1_1$ des ersten Satzes die erste Primärelektrode bildet und eine erste Elektrode $E2_1$ des zweiten Satzes die zweiten Primärelektroden bildet.

5. Hochspannungssensor nach Anspruch 4, wobei für jeden Satz j von Elektroden die Elektroden $Ej_i$ und $Ej_{i+1}$ sich axial entlang eines Überlappungsabschnitts überlappen, wobei im Überlappungsabschnitt die Elektrode $Ej_{i+1}$ von der Elektrode $Ej_i$ aus radial nach außen angeordnet ist.

6. Hochspannungssensor nach einem der Ansprüche 4 bis 5, wobei für jeden Satz j von Elektroden
jede Elektrode ein Mittelende (14), das der Bezugsebene (16; 160, 161) zugewandt ist, und ein Kontaktende (15) hat, das dem Mittelende (14) axial gegenüberliegt,
das Mittelende (14) der Elektrode $Ej_{i+1}$ der Referenzebene (16; 160, 161) näher als das Mittelende (14) der Elektrode $Ej_i$ ist, und das Kontaktende (15) der Elektrode $Ej_{i+1}$ der Bezugsebene (16; 160, 161) näher ist als das Kontaktende (15) der Elektrode $Ej_i$,
das Mittelende (14) der Elektrode $Ej_{i+1}$ einen axialen Abstand $Bj_i$ vom Mittelende (15) der Elektrode $Ej_i$ hat, und das Kontaktende (14) der Elektrode $Ej_{i+1}$ einen axialen Abstand $Cj_i$ vom Kontaktende (14) der Elektrode $Ej_i$ hat, und die Elektroden $Ej_i$ und $Ej_{i+1}$ sich axial zwischen dem Kontaktende (15) der Elektrode $Ej_{i+1}$ und dem Mittelende (14) der Elektrode $Ej_i$ überlappen.

7. Hochspannungssensor nach Anspruch 6, wobei für jeden Satz j von Elektroden der axiale Abstand $Bj_i$ kleiner als der axiale Abstand $Cj_i$ ist, und/oder wobei jeder Satz j der Elektroden einen anderen i-ten axialen Abstand $Bj_i$ hat (z.B. $B1_i \neq B2_i$) und/oder einen anderen i-ten axialen Abstand $C1_i$ hat (z.B. $C1_i \neq C2_i$).

8. Hochspannungssensor nach einem der Ansprüche 6 bis 7, wobei für jeden Satz j von Elektroden die axialen Abstände $Bj_i$ im Wesentlichen gleich einem gemeinsamen Abstand B sind und/oder die axialen Abstände $Cj_i$ im Wesentlichen gleich einem gemeinsamen Abstand C sind.

9. Hochspannungssensor nach einem der Ansprüche 4 bis 8 und nach Anspruch 2, wobei die Abschirmungselektrode ($E_s$) sich axial mit mindestens einer Elektrode des ersten Satzes und mindestens einer Elektrode des zweiten Satzes überlappt,

und wobei insbesondere die Schirmelektrode ($E_s$) sich axial mit einer radial am äußersten gelegenen Elektrode ($E1_6$) des ersten Satzes und einer radial am äußersten gelegenen Elektrode ($E2_6$) des zweiten Satzes überlappt und radial außerhalb der am äußersten gelegenen Elektroden ($E1_6$, $E2_6$) des ersten und zweiten Satzes angeordnet ist.

10. Hochspannungssensor nach einem der Ansprüche 4 bis 9, wobei die Elektroden nicht-symmetrisch in Bezug auf die Bezugsebene (16, 160, 161) angeordnet sind, und/oder wobei die Elektroden in Isoliermaterial eingebettet sind, das unterschiedliche dielektrische Konstanten auf beiden Seiten der Bezugsebene (16, 160, 161) umfasst.

11. Hochspannungssensor nach einem der Ansprüche 4 bis 10, wobei für mindestens einen Sensorhohlraum (7; 70, 71) der erste Satz von Elektroden $E1_i$ eine erste Kapazität ($C_1$, $C_3$) bildet und der zweite Satz von Elektroden $E2_i$ eine zweite Kapazität ($C_2$, $C_4$) bildet, und wobei insbesondere die erste Kapazität ($C_1$, $C_3$) und die zweite Kapazität ($C_2$, $C_4$) größer gemacht werden als jede Streukapazität, die in einem montierten Zustand des Hochspannungssensors vorhanden ist, und/oder wobei ein Verhältnis der ersten und der zweiten Kapazität ($C_1/C_2$, $C_3/C_4$) im Bereich von 1,1 bis 1,5 liegt.

12. Hochspannungssensor nach Anspruch 11, wobei zur Erhöhung der ersten Kapazität ($C_1$, $C_3$) über die zweite Kapazität ($C_2$, $C_4$) :

der erste Satz von Elektroden $E1_i$ aus i-ten Elektroden $E1_i$ längere axiale Längen als die i-ten Elektroden $E2_i$ des zweiten Satzes aufweist oder diese umfasst; und/oder der erste Satz von Elektroden $E1_i$ eine andere Anzahl von Elektroden umfasst als der zweite Satz von Elektroden $E2_i$; und/oder der erste Satz von Elektroden $E1_i$ einen unterschiedlichen Abstand (P) zwischen den Elektroden $E1_i$ umfasst im Vergleich zum zweiten Satz von Elektroden $E2_i$; und/oder ausgewählte benachbarte Elektroden im ersten und/oder zweiten Satz elektrisch kurzgeschlossen sind; und/oder der erste Satz von Elektroden $E1_i$ Isolationsmaterial mit höherer Dielektrizitätskonstante als der zweite Satz von Elektroden $E2_i$ umfasst.

13. Hochspannungssensor nach einem der Ansprüche 4 bis 9, wobei die Elektroden $E1_i$ des ersten Satzes gleichmäßig in radialer Richtung angeordnet sind und wobei die Elektroden $E2_i$ des zweiten Satzes gleichmäßig in radialer Richtung angeordnet sind, und/oder wobei die Elektroden symmetrisch in Bezug auf eine Bezugsebene (16; 160, 161) angeordnet sind, die sich radial durch den Sensorhohlraum (7; 70, 71) erstreckt, und/oder wobei mindestens ein Teil, insbesondere alle, der Elektroden ($E_{ji}$, $E_s$) im Wesentlichen zylindrisch und/oder koaxial zueinander sind.

14. Hochspannungssensor nach einem der vorhergehenden Ansprüche, wobei der Feldsensor (6) ein optischer Sensor zur Einführung einer feldabhängigen Phasenverschiebung zwischen einer ersten Polarisation oder einem ersten Modus oder einer zweiten Polarisation oder einem zweiten Modus des Lichts, das durchläuft, und insbesondere wobei der optische Sensor umfasst:

eine elektro-optische Vorrichtung mit feldabhängiger Doppelbrechung, insbesondere ein Kristall, insbesondere von kristallinem $Bi_4Ge_3O_{12}$ (BGO) oder $Bi_4Si_3O_{12}$ (BSO) oder einem gepolten Wellenleiter, der einen Pockels-Effekt aufweist, oder
eine piezoelektrische Einrichtung, insbesondere aus kristallinem Quarz oder einer piezoelektrischen Keramik, und einen Wellenleiter, der mindestens zwei Modi aufweist, wobei der Wellenleiter mit der piezoelektrischen Vorrichtung derart verbunden ist, dass eine Länge des Wellenleiters feldabhängig ist.

15. Hochspannungssensor nach Anspruch 14, wobei der Feldsensor (6) zwei optische Ausgangskanäle mit einer gegenseitigen Phasenverschiebung hat, die kein Vielfaches von n ist, und die insbesondere eine gegenseitige Phasenverschiebung von im Wesentlichen n/2 ist.

16. Hochspannungssensor nach einem der vorhergehenden Ansprüche, wobei ein erstes Ende (60) des Feldsensors (6) eine Kontaktelektrode (64) hat, die elektrisch angeschlossen ist, insbesondere durch einen Draht (66), an den ersten Kontaktpunkt (2; 20, 21), und ein zweites Ende (62) des Feldsensors (6) eine weitere Kontaktelektrode (64) hat, die elektrisch angeschlossen ist, insbesondere durch einen Draht (66), an den zweiten Kontaktpunkt (3; 30, 31), wobei insbesondere mindestens eine der Kontaktelektroden (64) einen vorderen Teil (640) zur Aufnahme einer flexiblen Verbindung (641), insbesondere ein Gummi-O-Ring oder Silikon, mit dem elektrischen Feldsensor (6) aufweist, und/oder wobei der vordere Teil (640) abgerundete Kanten zur Minimierung der Beanspruchung durch das elektrische Feld am Ende (60, 62) des elektrischen Feldsensors (6) hat und für einen feldfreien Hohlraum (642) als Entlüftungsvolumen (642) während eines Einbettungsverfahrens des elektrischen Feldsensors (6) in das isolierende Material sorgt, insbesondere in kompressibles Silikon oder Polyurethanschaum,

oder wobei insbesondere mindestens eine der Kontaktelektroden (64) Zentrierzapfen (648) zum radialen Zentrieren des elektrischen Feldsensors (6) in einer Bohrung (5) des Hochspannungssensors umfasst und/oder wobei mindestens eine der Kontaktelektroden (64) aus einem elastischen Material hergestellt ist, wie z. B. elektrisch leitendem Kautschuk oder Elastomer, oder aus einem elektrisch leitfähigen formbaren Polymermaterial, wie beispielsweise elektrisch leitfähigen thermoplastischen oder duroplastischen Materialien.

**17.** Hochspannungssensor nach Anspruch 16, wobei mindestens eine der Kontaktelektroden (64) einen Rückenteil (643) umfasst, der ein Innenvolumen (645) zur Aufnahme einer Optikanordnung (180) zum optischen Verbinden des Feldsensors (6) mit einem optischen Kabel (480) bereitstellt, und wobei insbesondere das Innenvolumen (645) eine Dichtung (644) und/oder eine Füllsubstanz zum Schutz der Optikanordnung (180) vor der Einwirkung des isolierenden Materials hat.

**18.** Hochspannungssensor nach einem der vorhergehenden Ansprüche, wobei der Isolator (1) einen Feststoff, eine Flüssigkeit, ein Gas oder Vakuum umfasst, und wobei insbesondere der Isolator (1) im Inneren eines Hohlhochspannungsaußenisolators (25) platziert ist, vorzugsweise aus faserverstärktem Epoxidharzrohr mit einem Außenschirmisolator (19), vorzugsweise aus Silikon-Elastomer, hergestellt, zur Aufnahme des Isolators (1) in seinem hohlen Kern, der den Sensorhohlraum (7; 70, 71) und einen Zwischenraum außerhalb des Isolators (1) zur Aufnahme von optischen Fasern umfasst, wie z. B. eine Rückleitungsfaser (27) oder eine Übertragungsfaser (26) zum optischen Verbinden weiterer Sensormodulgehäuse oder anderer optischer Sensoren, und wobei der Spalt gefüllt ist, insbesondere mit Polyurethanschaum,

und/oder wobei optische Fasern, wie beispielsweise eine Rückleitungsfaser (27) oder eine Übertragungsfaser (26) zum optischen Verbinden weiterer Sensormodulgehäuse oder anderer optischer Sensoren, innerhalb einer Bohrung (5) des Isolators (1) installiert sind, die den Sensorhohlraum (7; 70, 71) umfasst und wobei die Bohrung (5) gefüllt ist, insbesondere mit kompressiblem Silikon,

und/oder wobei der Isolator (1), der den Sensorhohlraum (7; 70, 71) umfasst, eine schraubenförmige Nut an seiner Außenseite hat, und optische Fasern, wie beispielsweise eine Rückleitungsfaser (27) oder eine Übertragungsfaser (26) zum optischen Verbinden weiterer Sensormodulgehäuse oder anderer optischer Sensoren, in der Nut installiert und überformt sind, vorzugsweise durch Silikon, um einen externen Schirmisolator (19) direkt auf dem Isolator (1) zu bilden,

und/oder wobei der Isolator (1), der den Sensorhohlraum (7; 70, 71) umfasst, aus mit Harz imprägniertem Papier oder Faserisolierung hergestellt ist, und optische Fasern, wie beispielsweise eine Rückleitungsfaser (27) oder eine Übertragungsfaser (26) zum optischen Verbinden weiterer Sensormodulgehäuse oder anderer optischer Sensoren, in das harzgetränkte Papier oder die Faserisolierung beim Wickeln eingebettet sind.

**19.** Anordnung von mehreren, insbesondere identischen, Hochspannungssensoren nach einem der vorhergehenden Ansprüche, die in Reihe angeordnet sind.

**20.** Anordnung nach Anspruch 19 mit mehreren Hochspannungssensoren nach Anspruch 15, wobei ein optischer Verzögerer (38), insbesondere ein $\lambda$/4-Retarder, nur einer Teilmenge von Feldsensoren (6) zugeordnet ist, für eine zusätzliche Phasenverzögerung für das Licht, das durch den Feldsensor (6) läuft,

und/oder wobei eine Teilmenge der Feldsensoren (6), insbesondere einer der Feldsensoren (6), dimensioniert wird, um eine Phasenverschiebung, die wesentlich von den Phasenverschiebungen der übrigen Feldsensoren (6) verschieden ist, zu erzeugen, insbesondere eine Phasenverschiebung von $\pm$ n/2 oder weniger bei einer maximalen Spannung, die von der Baugruppe gemessen werden soll,

und/oder wobei nur eine Teilmenge der Hochspannungssensoren mit einem Feldsensor ausgestattet ist.

**21.** Anordnung nach einem der Ansprüche 19 bis 20, wobei die Kontaktpunkte (2, 3, 20, 30, 21, 31) mit Metallkontakten (4) ausgestattet sind, und die Hochspannungsseite des obersten Metallkontaktes (4) der Anordnung den größten Durchmesser aller Metallkontakte (4) hat,

und/oder wobei optische Verbindungsstellen für optische Fasern in einem Hohlraum in einer mechanischen Verbindung zwischen benachbarten Hochspannungssensoren angeordnet sind, und wobei insbesondere eine seitliche Öffnung in dem mechanischen Verbinder für den Zugang zu den optischen Fasern und zum Spleißen der optischen Fasern bereitgestellt ist.

**Revendications**

1. Capteur de haute tension destiné à mesurer une tension entre un premier et un deuxième point (2, 3, 20, 30, 21, 31) de contact comportant

   un isolateur (1) en matériau isolant s'étendant suivant une direction axiale entre les premier et deuxième points (2, 3, 20, 30, 21, 31) de contact,

   une pluralité d'électrodes conductrices $(Ei_j, E_S)$ disposées dans ledit isolateur (1), lesdites électrodes $(Ei_j, E_S)$ étant séparées les unes des autres par ledit matériau isolant et couplées de façon capacitive les unes aux autres,

   au moins un capteur (6) de champ électrique disposé dans au moins une cavité (7 ; 70, 71) de détection, en particulier dans exactement une cavité (7) de détection, dudit isolateur (1),

   **caractérisé en ce que**, pour au moins une partie desdites électrodes $(Ei_j, E_S)$, chaque électrode chevauche axialement au moins une autre desdites électrodes $(Ei_j, E_S)$,

   lesdites électrodes $(Ei_j, E_S)$ étant disposées en vue de générer dans ladite cavité (7 ; 70, 71) de détection un champ électrique présentant une intensité moyenne de champ supérieure à ladite tension divisée par une distance entre lesdits premier et deuxième points (2, 3, 20, 30, 21, 31) de contact, et

   le capteur de haute tension comportant au moins une première électrode primaire $(E1_1)$ reliée électriquement au premier point (2 ; 20, 21) de contact et une deuxième électrode primaire $(E2_1)$ reliée électriquement au deuxième point (3 ; 30, 31) de contact et lesdites électrodes $(Ei_j, E_S)$ formant un diviseur capacitif de tension entre les première et deuxièmes électrodes primaires $(E1_1, E2_1)$ .

2. Capteur de haute tension selon la revendication 1, au moins une desdites électrodes $(Ei_j, E_S)$ étant une électrode $(E_S)$ de blindage entourant radialement ladite cavité (7 ; 70, 71) de détection, un diamètre extérieur du capteur de haute tension étant en particulier agrandi à des emplacements axiaux présentant une intensité de champ électrique élevée ou supérieure à la moyenne et étant réduit à des emplacements axiaux présentant une intensité de champ électrique faible ou inférieure à la moyenne et, en outre, le diamètre étant en particulier accru autour d'une position axiale d'extrémité inférieure de l'électrode $(E_S)$ de blindage.

3. Capteur de haute tension selon l'une quelconque des revendications précédentes, ledit capteur (6) de champ se chevauchant axialement avec ladite première électrode primaire $(E1_1)$ ainsi qu'avec ladite deuxième électrode primaire $(E2_1)$ et, en particulier ledit capteur (6) de champ électrique mesurant l'intégrale curviligne du champ sur une longueur 1 dudit capteur (6) de champ, ou ledit ou lesdits capteurs (6) de champ électrique étant un capteur de champ électrique local qui mesure ledit champ sur une partie seulement de l'étendue axiale de la cavité de détection.

4. Capteur de haute tension selon l'une quelconque des revendications précédentes, lesdites électrodes $(Ei_j, E_S)$ comportant, pour chaque cavité (7 ; 70, 71) de détection, un premier ensemble d'électrodes $E1_i$ avec i = 1... nul et un deuxième ensemble d'électrodes $E2_i$ avec i = 1...N2, les électrodes $E1_i$ du premier ensemble étant disposées dans une première région (10) dudit isolateur (1), ladite première région (10 ; 100, 101) s'étendant d'un plan (16 ; 160, 161) de référence de ladite cavité (7 ; 70, 71) de détection audit premier point (2 ; 20, 21) de contact, et les électrodes $E2_i$ du deuxième ensemble étant disposées dans une deuxième région (11 ; 110, 111) dudit isolateur (1), ladite deuxième région (11 ; 110, 111) s'étendant dudit plan (16 ; 160, 161) de référence audit deuxième point (3 ; 30, 31) de contact, ledit plan (16 ; 160, 161) de référence s'étendant radialement à travers ladite cavité (7 ; 70, 71) de détection, en particulier N1 = N2, et en particulier une première électrode $E1_1$ dudit premier ensemble formant ladite première électrode primaire et une première électrode $E2_1$ dudit deuxième ensemble formant lesdites deuxièmes électrodes primaires.

5. Capteur de haute tension selon la revendication 4, les électrodes $Ej_i$ et $Ej_{i+1}$, pour chaque ensemble j d'électrodes, se chevauchant axialement le long d'un tronçon de chevauchement, l'électrode $Ej_{i+1}$ étant, dans ledit tronçon de chevauchement, disposée extérieurement dans le sens radial par rapport à l'électrode $Ej_i$.

6. Capteur de haute tension selon l'une quelconque des revendications 4 à 5, **caractérisé en ce que**, pour chaque ensemble j d'électrodes,

   chaque électrode présente une extrémité (14) de centre faisant face audit plan (16 ; 160, 161) de référence et une extrémité (15) de contact opposée axialement à ladite extrémité (14) de centre,

   l'extrémité (14) de centre de l'électrode $Ej_{i+1}$ est plus proche dudit plan (16 ; 160, 161) de référence que l'extrémité (14) de centre de l'électrode $Ej_i$, et l'extrémité (15) de contact de l'électrode $Ej_{i+1}$ est plus proche dudit plan (16 ; 160, 161) de référence que l'extrémité (15) de contact de l'électrode $Ej_i$, l'extrémité (14) de centre de l'électrode $Ej_{i+1}$ se trouve à une distance axiale $Bj_i$ de l'extrémité (15) de centre de l'électrode $Ej_i$, et l'extrémité (14) de contact

de l'électrode $Ej_{i+1}$ se trouve à une distance axiale $Cj_i$ de l'extrémité (14) de contact de l'électrode $Ej_i$, et les électrodes $Ej_i$ et $Ej_{i+1}$ se chevauchent axialement entre l'extrémité (15) de contact de l'électrode $Ej_{i+1}$ et l'extrémité (14) de centre de l'électrode $Ej_i$.

7. Capteur de haute tension selon la revendication 6, la distance axiale $Bj_i$ étant, pour chaque ensemble j d'électrodes, inférieure à la distance axiale $Cj_i$, et / ou chaque ensemble j d'électrodes présentant une i-ème distance axiale $Bj_i$ différente (par ex. $B1_i \neq B2_i$) et / ou une i-ème distance axiale $Cl_i$ différente (par ex. $C1_i \# C2_i$).

8. Capteur de haute tension selon l'une quelconque des revendications 6 à 7, **caractérisé en ce que** pour chaque ensemble j d'électrodes, les distances axiales $Bj_i$ sont sensiblement égales à une distance commune B et / ou les distances axiales $Cj_i$ sont sensiblement égales à une distance commune C.

9. Capteur de haute tension selon l'une quelconque des revendications 4 à 8 et de claim 2, ladite électrode $(E_S)$ de blindage se chevauchant axialement avec au moins une électrode dudit premier ensemble et au moins une électrode dudit deuxième ensemble,

et, en particulier, l'électrode $(E_S)$ de blindage se chevauchant axialement avec une électrode $(E1_6)$ située radialement le plus à l'extérieur dudit premier ensemble et une électrode $(E2_6)$ située radialement le plus à l'extérieur dudit deuxième ensemble et étant disposée extérieurement dans le sens radial par rapport auxdites électrodes $(E1_6, E2_6)$ situées radialement le plus à l'extérieur desdits premier et deuxième ensembles.

10. Capteur de haute tension selon l'une quelconque des revendications 4 à 9, lesdites électrodes étant disposées asymétriquement par rapport au plan (16, 160, 161) de référence et / ou lesdites électrodes étant enrobées dans du matériau isolant présentant des constantes diélectriques différentes de part et d'autre du plan (16, 160, 161) de référence.

11. Capteur de haute tension selon l'une quelconque des revendications 4 à 10, **caractérisé en ce que**, pour au moins une cavité (7 ; 70, 71) de détection, le premier ensemble d'électrodes $E1_i$ forme une première capacité $(C_1, C_3)$ et le deuxième ensemble d'électrodes $E2_i$ forme une deuxième capacité $(C_2, C_4)$, et en particulier **en ce que** la première capacité $(C_1, C_3)$ et la deuxième capacité $(C_2, C_4)$ sont prises supérieures à une quelconque capacité parasite présente dans un état monté du capteur de haute tension et / ou **en ce qu'**un rapport des première et deuxième capacités $(C_1/C_2, C_3/C_4)$ se situe dans la plage de 1,1 to 1,5.

12. Capteur de haute tension selon la revendication 11, **caractérisé en ce que**, pour accroître la première capacité $(C_1, C_3)$ par rapport à la deuxième capacité $(C_2, C_4)$ :

le premier ensemble d'électrodes $E1_i$ comporte ou est constitué de i-èmes électrodes $E1_i$ présentant des longueurs axiales supérieures à celles des i-èmes électrodes $E2_i$ du deuxième ensemble ; et / ou le premier ensemble d'électrodes $E1_i$ comporte un nombre d'électrodes différent de celui du deuxième ensemble d'électrodes $E2_i$ ; et / ou le premier ensemble d'électrodes $E1_i$ comporte un espacement (P) différent entre les électrodes $E1_i$ par comparaison au deuxième ensemble d'électrodes $E2_i$ ; et / ou des électrodes voisines choisies dans le premier et / ou le deuxième ensemble sont électriquement court-circuitées ; et / ou le premier ensemble d'électrodes $E1_i$ comporte un matériau isolant d'une constante diélectrique supérieure à celle du deuxième ensemble d'électrodes E2i.

13. Capteur de haute tension selon l'une quelconque des revendications 4 à 9, les électrodes $E1_i$ dudit premier ensemble étant espacées uniformément dans la direction radiale et les électrodes $E2_i$ dudit deuxième ensemble étant espacées uniformément dans la direction radiale, et / ou lesdites électrodes étant disposées symétriquement par rapport à un plan (16 ; 160, 161) de référence s'étendant radialement à travers ladite cavité (7 ; 70, 71) de détection, et / ou au moins une partie, en particulier la totalité, desdites électrodes $(Ej_i, E_S)$ étant sensiblement cylindriques et / ou coaxial les unes aux autres.

14. Capteur de haute tension selon l'une quelconque des revendications précédentes, ledit capteur (6) de champ étant un capteur optique introduisant un déphasage dépendant du champ entre une première polarisation ou un premier mode et une deuxième polarisation ou un deuxième mode d'une lumière le traversant, et ledit capteur optique comportant en particulier

un dispositif électro-optique à biréfringence dépendant du champ, en particulier un cristal, en particulier du $Bi_4Ge_3O_{12}$ (BGO) ou du $Bi_4Si_3O_{12}$ (BSO) cristallin, ou un guide d'ondes à pôles présentant un effet Pockels, ou un dispositif piézoélectrique, en particulier en quartz cristallin ou en céramique piézoélectrique, et un guide d'ondes transportant au moins deux modes, ledit guide d'ondes étant relié audit dispositif piézoélectrique de telle façon qu'une longueur dudit guide d'ondes soit dépendante du champ.

15. Capteur de haute tension selon la revendication 14, ledit capteur (6) de champ comprenant deux canaux de sortie optique présentant un déphasage mutuel qui n'est pas un multiple de $\pi$, et en particulier qui est un déphasage mutuel sensiblement de $\pi/2$.

16. Capteur de haute tension selon l'une quelconque des revendications précédentes, une première extrémité (60) dudit capteur (6) de champ comprenant une électrode (64) en contact qui est reliée électriquement, en particulier via un fil (66), audit premier point (2 ; 20, 21) de contact, et une deuxième extrémité (62) dudit capteur (6) de champ comprenant une autre électrode (64) en contact qui est reliée électriquement, en particulier via un fil (66), audit deuxième point (3 ; 30, 31) de contact,
en particulier, au moins une des électrodes (64) en contact comportant une partie avant (640) destinée à loger une liaison souple (641), en particulier un joint torique en caoutchouc ou du silicone, vers le capteur (6) de champ électrique, et / ou la partie avant (640) présentant des bords arrondis pour minimiser la contrainte de champ électrique à l'extrémité (60, 62) du capteur (6) de champ électrique et ménageant une cavité (642) libre de champ en tant que volume (642) de dégagement d'air pendant une procédure d'encastrement du capteur (6) de champ électrique dans le matériau isolant, en particulier dans une mousse compressible de silicone ou de polyuréthane,
ou, en particulier, au moins une des électrodes (64) en contact comportant des broches (648) de centrage servant à centrer radialement le capteur (6) de champ électrique dans un alésage (5) du capteur de haute tension, et / ou au moins une des électrodes (64) en contact étant réalisée à partir d'un matériau élastique, tel qu'un caoutchouc ou élastomère électriquement conducteur, ou d'un matériau polymérique moulable électriquement conducteur, tel qu'un matériau thermoplastique ou thermodurcissable électriquement conducteur.

17. Capteur de haute tension selon la revendication 16, au moins une des électrodes (64) en contact comportant une partie arrière (643) qui ménage un volume interne (645) destiné à loger un ensemble (180) d'optique servant à relier optiquement le capteur (6) de champ à un câble optique (480) et, en particulier, le volume interne (645) étant doté d'une substance d'étanchéité (644) et / ou de remplissage destinée à protéger l'ensemble (180) d'optique contre une exposition au matériau isolant.

18. Capteur de haute tension selon l'une quelconque des revendications précédentes, l'isolateur (1) comportant un solide, un liquide, un gaz ou du vide et, en particulier, l'isolateur (1) étant placé à l'intérieur d'un isolateur extérieur (25) haute tension à âme creuse, de préférence constitué d'un tube en époxy renforcé par des fibres, avec un isolateur externe (19) à cloche, de préférence constitué d'élastomère de silicone, destiné à loger dans son âme creuse l'isolateur (1), qui comporte la cavité (7 ; 70, 71) de détection, et un interstice extérieur à l'isolateur (1) destiné à recevoir des fibres optiques, comme une fibre (27) de retour ou une fibre (26) d'émission destinée à raccorder optiquement des corps supplémentaires de modules de capteur ou d'autres capteurs optiques, et l'interstice étant rempli, en particulier de mousse de polyuréthane,
et / ou des fibres optiques, comme une fibre (27) de retour ou une fibre (26) d'émission destinée à raccorder optiquement des corps supplémentaires de modules de capteur ou d'autres capteurs optiques, étant montées à l'intérieur d'un alésage (5) de l'isolateur (1), qui comporte la cavité (7 ; 70, 71) de détection, et l'alésage (5) étant rempli, en particulier de silicone compressible,
et / ou l'isolateur (1), qui comporte la cavité (7 ; 70, 71) de détection, présentant une rainure de forme hélicoïdale sur son extérieur, et des fibres optiques, comme une fibre (27) de retour ou une fibre (26) d'émission destinée à raccorder optiquement des corps supplémentaires de modules de capteur ou d'autres capteurs optiques, étant montées dans la rainure et étant surmoulées, de préférence par du silicone, pour former un isolateur externe (19) à cloche directement par-dessus l'isolateur (1),
et / ou l'isolateur (1), qui comporte la cavité (7 ; 70, 71) de détection, étant constitué de papier imprégné de résine ou d'isolation en fibre, et des fibres optiques, comme une fibre (27) de retour ou une fibre (26) d'émission destinée à raccorder optiquement des corps supplémentaires de modules de capteur ou d'autres capteurs optiques, étant enrobées dans le papier imprégné de résine ou l'isolation en fibre pendant l'enroulement.

19. Ensemble de plusieurs capteurs de haute tension, en particulier identiques, selon l'une quelconque des revendications précédentes, disposés en série.

20. Ensemble selon la revendication 19 comportant plusieurs capteurs de haute tension selon la revendication 15, un retardateur optique (38), en particulier un retardateur $\lambda/4$, étant attribué seulement à un sous-ensemble des capteurs (6) de champ, pour ajouter un retard de phase supplémentaire à une lumière traversant le capteur (6) de champ,

et / ou un sous-ensemble desdits capteurs (6) de champ, en particulier un desdits capteurs (6) de champ, étant dimensionné(s) pour générer un déphasage qui est sensiblement différent des déphasages des capteurs (6) de champ restants, en particulier un déphasage de $\pm\pi/2$ ou moins à une tension maximale à mesurer dudit ensemble, et / ou seulement un sous-ensemble de capteurs de haute tension étant équipé d'un capteur de champ.

21. Ensemble selon l'une quelconque des revendications 19 à 20, les points (2, 3, 20, 30, 21, 31) de contact étant équipés de contacts métalliques (4), et le contact métallique (4) extrême supérieur côté haute tension de l'ensemble présentant le plus grand diamètre de tous les contacts métalliques (4),
et / ou des épissures optiques pour fibres optiques étant placées à l'intérieur d'un volume creux en liaison mécanique entre des capteurs de haute tension voisins et, en particulier, une ouverture latérale étant pratiquée dans le connecteur mécanique pour donner accès aux fibres optiques et pour réaliser l'épissure des fibres optiques.

Fig. 1

**Fig. 2**

(a)

Sensing element section

(b)

Fig. 3

Fig. 4

Fig. 5

EP 2 577 328 B1

Digital output
IEC 61850-9-2

**Fig. 6**

**Fig. 7**

Fig. 8

(a)

(b)

(a)

(b)

Fig. 9

Fig 10

EP 2 577 328 B1

Fig. 11

Fig. 12

(a)                    (b)

**Fig. 13**

EP 2 577 328 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4904931 A
- US 6252388 B
- CH 547496
- US 4904931 B
- US 5715058 B
- US 6380725 B
- US 6140810 B
- US 6876188 B
- US 3875327 B
- US 4362897 A
- EP 1939897 A1
- US 5001419 A
- WO 9805975 A
- US 5029273 A
- US 5936395 A
- US 6348786 B
- EP 0789245 A2

**Non-patent literature cited in the description**

- **L. DUVILLARET ; S. RIALLAND ; J.-L. COUTAZ.** Electro-optic sensors for electric field measurements. II. Choice of the crystal and complete optimization of their orientation. *J. Opt. Soc. Am. B,* 2002, vol. 19, 2704
- **N.A.F. JAEGER et al.** *IEEE Trans. Power Deliv.,* 1995, vol. 10, 127
- **K. BOHNERT et al.** *Optical Engineering,* 2000, vol. 39 (11), 3060